# EUROPEAN PATENT APPLICATION

(11) **EP 4 447 633 A1**
(43) Date of publication of application: **16.10.2024**
(21) Application number: 22953473.0
(22) Date of filing: 02.08.2022
(51) Int. Cl.: H10K 50/11, H10K 50/14

(54) **ARRAY SUBSTRATE, MANUFACTURING METHOD THEREFOR, AND DISPLAY APPARATUS**

(71) Applicant: BOE Technology Group Co., Ltd., Beijing 100015 (CN); Beijing BOE Technology Development Co., Ltd., Beijing 100176 (CN)
(72) Inventor: LI, Zhuo, Beijing 100176 (CN)
(74) Representative: Studio Torta S.p.A.
(86) International application number: PCT/CN2022/109613
(87) International publication number: WO 2024/026658

(57) **Abstract**

The present disclosure provides an array substrate, a manufacturing method thereof, and a display device. The array substrate includes: a base substrate including a plurality of sub-pixels arranged in an array; a patterned metal oxide layer on the base substrate and in the plurality of sub-pixels, a portion of the metal oxide layer in any one of the plurality of sub-pixels being spaced apart from a portion of the metal oxide layer in another sub-pixel adjacent to the any one sub-pixel; and a patterned light-emitting layer on a side of the metal oxide layer away from the base substrate and in the plurality of sub-pixels. The metal oxide layer includes at least one of magnesium element and calcium element, and the light-emitting layer includes a photosensitive material and is in contact with the metal oxide layer.

## Description

### TECHNICAL FIELD

The present disclosure relates to the field of display technology, and in particular, to an array substrate, a manufacturing method thereof, and a display device comprising the array substrate.

### BACKGROUND

Light emitting diode (LED) emits light by releasing energy through the recombination of electrons and holes. Light emitting diodes comprise, but are not limited to, organic light emitting diodes (OLEDs) and quantum dot light emitting diodes (QLEDs). Quantum dots are semiconductor nanomaterials that can trap excitons in the three-dimensional space. Due to the excellent properties, such as high quantum efficiency, narrow excitation spectrum, high stability of light, long fluorescence lifetime, and good solution processing compatibility, quantum dots have huge application potential in high color quality display. Quantum dot light emitting diodes are devices that use quantum dots as light emitting materials, compared with organic light emitting diodes, quantum dot light emitting diodes have outstanding advantages such as lower energy consumption, higher color purity, and wider color gamut, so quantum dot light emitting technology has become the most promising next-generation self-light-emitting display technology.

### SUMMARY

According to an aspect of the present disclosure, an array substrate is provided. The array substrate comprises a base substrate comprising a plurality of sub-pixels arranged in an array; a patterned metal oxide layer on the base substrate and in the plurality of sub-pixels, a portion of the metal oxide layer in any one of the plurality of sub-pixels being spaced apart from a portion of the metal oxide layer in another sub-pixel adjacent to the any one sub-pixel; and a patterned light-emitting layer on a side of the metal oxide layer away from the base substrate and in the plurality of sub-pixels. The metal oxide layer comprises at least one of magnesium element and calcium element, and the light-emitting layer comprises a photosensitive material and is in contact with the metal oxide layer.

In some embodiments, the metal oxide layer comprises the magnesium element.

In some embodiments, a material of the metal oxide layer comprises an oxide nanoparticle comprising the magnesium element, and a surface of the oxide nanoparticle comprising the magnesium element has photosensitive ligand molecules.

In some embodiments, a structural formula of the oxide nanoparticle comprising the magnesium element is 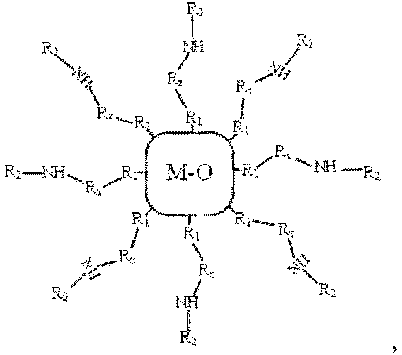 the surface of the oxide nanoparticle having the photosensitive ligand molecules. M-O represents the oxide nanoparticle comprising the magnesium element, 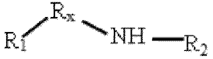 represents a respective one of the photosensitive ligand molecules, R₁ is selected from one of hydroxyl, sulfydryl, amino, carbonyl, carboxyl and ester group, R₂ is selected from one of hydrogen atom, methyl, ethyl, propyl and isopropyl, and Rₓ is an aliphatic alkane chain with 1 to 6 carbon atoms.

In some embodiments, a structural formula of the oxide nanoparticle comprising the magnesium element is 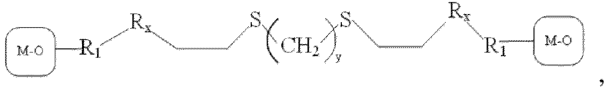 the surface of the oxide nanoparticle having the photosensitive ligand molecules. M-O represents the oxide nanoparticle comprising the magnesium element, 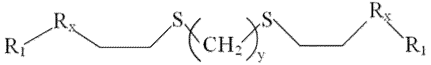 represents a respective one of the photosensitive ligand molecules between two adjacent oxide nanoparticles comprising the magnesium element, R₁ is selected from one of hydroxyl, sulfydryl, amino, carbonyl, carboxyl and ester group, Rₓ is an aliphatic alkane chain with 1 to 18 carbon atoms or a carbon molecular chain, a main chain of the carbon molecular chain comprises one of nitrogen atom, oxygen atom, and sulfur atom, 1≤y≤18.

In some embodiments, the array substrate further comprises a ruptured microcapsule, the ruptured microcapsule is between the base substrate and the light-emitting layer and exposes the metal oxide layer, a material of the microcapsule comprises a macromolecular material having at least one side chain, and the side chain comprises a reversible chemical bond.

In some embodiments, a material of the metal oxide layer comprises a crystal comprising the magnesium element.

In some embodiments, the light-emitting layer is a quantum dot, each sub-pixel comprises target quantum dots and non-target quantum dots which are residual and trace, and a number of the non-target quantum dots residual in a unit area of each sub-pixel is 0~500 pcs/µm².

In some embodiments, the number of the non-target quantum dots residual in the unit area of each sub-pixel is 0.5~85 pcs/µm².

In some embodiments, a material of the metal oxide layer is selected from at least one of MgO, ZnMgO, MgO with a dopant, or ZnMgO with a dopant, the MgO with the dopant or the ZnMgO with the dopant being doped with at least one of Al, Ga, Sn, In, or Ti.

In some embodiments, a content of the magnesium element in the metal oxide layer is greater than or equal to 1.5%, the content of the magnesium element in the metal oxide layer refers to a percentage of a molar amount of the magnesium element in the metal oxide layer to a sum of molar amounts of all metal elements in the metal oxide layer.

In some embodiments, a thickness of the metal oxide layer is less than or equal to 100 nm.

In some embodiments, the thickness of the metal oxide layer is less than or equal to 8 nm, and a maximum of a content of the magnesium element in the metal oxide layer is 1.5%~100%; or the thickness of the metal oxide layer is greater than or equal to 8 nm, and a maximum of a content of the magnesium element in the metal oxide layer is 1.5%~40%, the content of the magnesium element in the metal oxide layer refers to a percentage of a molar amount of the magnesium element in the metal oxide layer to a sum of molar amounts of all metal elements in the metal oxide layer.

In some embodiments, the thickness of the metal oxide layer is greater than or equal to 15 nm and less than or equal to 60 nm, and the maximum of the content of the magnesium element in the metal oxide layer is 2%~20%.

In some embodiments, the array substrate further comprises an electrode layer between the base substrate and the metal oxide layer, the metal oxide layer is in direct contact with a surface of the electrode layer away from the base substrate.

In some embodiments, the array substrate further comprises a pixel defining layer on the base substrate and between any two adjacent sub-pixels of the plurality of sub-pixels, the pixel defining layer comprising a sidewall and a top surface on a side away from the base substrate; and an electron transport layer in the plurality of sub-pixels and covering the sidewall and the top surface of the pixel defining layer, a portion of the electron transport layer in the plurality of sub-pixels being between the base substrate and the metal oxide layer.

In some embodiments, a material of the electron transport layer does not comprise magnesium.

In some embodiments, a material of the metal oxide layer is MgO, and a ratio of a thickness of the MgO to a thickness of the electron transport layer is 1:80-1:1.

In some embodiments, the metal oxide layer covers the sidewall of the pixel defining layer.

In some embodiments, an orthographic projection of the light-emitting layer on the base substrate substantially overlaps with an orthographic projection of the metal oxide layer on the base substrate.

In some embodiments, the array substrate further comprises: a first electrode layer between the base substrate and the metal oxide layer; a hole transport layer on a side of the light-emitting layer away from the base substrate; a hole injection layer on a side of the hole transport layer away from the base substrate; and a second electrode layer on a side of the hole injection layer away from the base substrate.

According to another aspect of the present disclosure, an array substrate is provided. The array substrate comprises a base substrate comprising a plurality of sub-pixels arranged in an array; a first electrode layer on the base substrate; a pixel defining layer on the base substrate and between any two adjacent sub-pixels of the plurality of sub-pixels, the pixel defining layer comprising a sidewall and a top surface on a side away from the base substrate; an electron transport layer on a side of the first electrode layer away from the base substrate, the electron transport layer being arranged in the plurality of sub-pixels and covering the sidewall and the top surface of the pixel defining layer; a patterned metal oxide layer on a side of the electron transport layer away from the base substrate and in the plurality of sub-pixels, a portion of the metal oxide layer in any one of the plurality of sub-pixels being spaced apart from a portion of the metal oxide layer in another sub-pixel adjacent to the any one sub-pixel by the pixel defining layer, the metal oxide layer comprising at least one of magnesium element and calcium element; a patterned light-emitting layer on a side of the metal oxide layer away from the base substrate and in the plurality of sub-pixels; a hole transport layer on a side of the light-emitting layer away from the base substrate; a hole injection layer on a side of the hole transport layer away from the base substrate; and a second electrode layer on a side of the hole injection layer away from the base substrate.

In some embodiments, a material of the electron transport layer does not comprise magnesium, a material of the metal oxide layer is MgO, and a ratio of a thickness of the MgO to a thickness of the electron transport layer is 1:80-1:1.

According to yet another aspect of the present disclosure, a display device is provided. The display device comprises the array substrate described in any of the previous embodiments; and a counter substrate opposite to the array substrate.

According to still another aspect of the present disclosure, a method of manufacturing an array substrate is provided. The method comprises: providing a base substrate that comprises a plurality of sub-pixels arranged in an array; forming a patterned metal oxide layer on the base substrate and forming a patterned light-emitting layer on a side of the metal oxide layer away from the base substrate. The metal oxide layer comprises at least one of magnesium element and calcium element, both the metal oxide layer and the light-emitting layer are in the plurality of sub-pixels, and a portion of the metal oxide layer in any one of the plurality of sub-pixels is spaced apart from a portion of the metal oxide layer in another sub-pixel adjacent to the any one sub-pixel, and the light-emitting layer comprises a photosensitive material and is in contact with the metal oxide layer.

In some embodiments, the plurality of sub-pixels comprise a first sub-pixel, a second sub-pixel, and a third sub-pixel, the forming the patterned metal oxide layer on the base substrate and forming the patterned light-emitting layer on the side of the metal oxide layer away from the base substrate, comprises: applying a first metal oxide film on the base substrate, patterning the first metal oxide film to form a first metal oxide pattern in the first sub-pixel; applying a first light-emitting layer film on a side of the first metal oxide pattern away from the base substrate, patterning the first light-emitting layer film to form a first light-emitting pattern in direct contact with the first metal oxide pattern in the first sub-pixel; applying a second metal oxide film on a side of the first light-emitting pattern away from the base substrate, patterning the second metal oxide film to form a second metal oxide pattern in the second sub-pixel; and applying a second light-emitting layer film on a side of the first light-emitting pattern and the second metal oxide pattern away from the base substrate, patterning the second light-emitting layer film to form a second light-emitting pattern in direct contact with the second metal oxide pattern in the second sub-pixel. The metal oxide layer comprises the first metal oxide pattern and the second metal oxide pattern, and the light-emitting layer comprises the first light-emitting pattern and the second light-emitting pattern.

In some embodiments, a bonding force between the light-emitting layer and the metal oxide layer is greater than a bonding force between the light-emitting layer and the base substrate.

In some embodiments, the first metal oxide film and the second metal oxide film have a photosensitive or thermo-sensitive property, and the first light-emitting layer film and the second light-emitting layer film have a photosensitive property.

In some embodiments, the first metal oxide pattern is prepared by following operations: applying the first metal oxide film on the base substrate, a material of the first metal oxide film comprising an oxide nanoparticle comprising the magnesium element, a surface of the oxide nanoparticle having photosensitive ligand molecules; exposing the first sub-pixel by using a mask to allow ultraviolet light to pass through the mask to expose the first metal oxide film, to cross-link the photosensitive ligand molecules; developing the first metal oxide film by using a developer to form the first metal oxide pattern in the first sub-pixel. The second metal oxide pattern is prepared by following operations: applying the second metal oxide film on the side of the first light-emitting pattern away from the base substrate, a material of the second metal oxide film comprising an oxide nanoparticle comprising the magnesium element, a surface of the oxide nanoparticle having photosensitive ligand molecules; exposing the second sub-pixel by using a mask to allow ultraviolet light to pass through the mask to expose the second metal oxide film, to cross-link the photosensitive ligand molecules; and developing the second metal oxide film by using a developer to form the second metal oxide pattern in the second sub-pixel.

In some embodiments, the first metal oxide pattern is prepared by following operations: applying the first metal oxide film on the base substrate, a material of the first metal oxide film comprising an oxide nanoparticle that comprises the magnesium element and is wrapped by a microcapsule, the microcapsule having a photosensitive or thermo-sensitive property; exposing the first sub-pixel by using a mask, irradiating the first metal oxide film by using ultraviolet light or heating the first metal oxide film to rupture the microcapsule in the first sub-pixel to expose the oxide nanoparticle comprising the magnesium element, so as to form the first metal oxide pattern in the first sub-pixel. The second metal oxide pattern is prepared by following operations: applying the second metal oxide film on the side of the first light-emitting pattern away from the base substrate, a material of the second metal oxide film comprising an oxide nanoparticle that comprises the magnesium element and is wrapped by a microcapsule, the microcapsule having a photosensitive or thermo-sensitive property; exposing the second sub-pixel by using a mask, irradiating the second metal oxide film by using ultraviolet light or heating the second metal oxide film to rupture the microcapsule in the second sub-pixel to expose the oxide nanoparticle comprising the magnesium element, so as to form the second metal oxide pattern in the second sub-pixel.

In some embodiments, a structural formula of the microcapsule is: 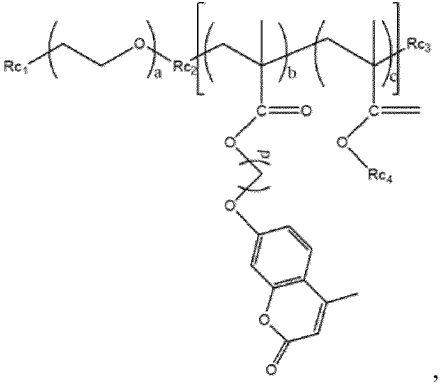 where Rc₁ and Rc₃ are hydrogen atoms or alkane groups, Rc₂ and Rc₄ are alkane groups, a≥60, b+c≥30 and b≥16, 1≤d≤20.

In some embodiments, the first metal oxide pattern is prepared by following operations: applying the first metal oxide film on the base substrate, a material of the first metal oxide film comprising an oxide precursor comprising the magnesium element; applying an intermediate layer with a photosensitive property on the side of the first metal oxide film away from the base substrate; exposing the first sub-pixel by using a mask to allow ultraviolet light to pass through the mask to expose the intermediate layer; dissolving an unexposed portion of the intermediate layer by using a developer to expose the oxide precursor comprising the magnesium element, and dissolving the exposed oxide precursor comprising the magnesium element by using a solvent; performing a high-temperature annealing process on the first sub-pixel, and forming the first metal oxide pattern by crystallizing the oxide precursor comprising the magnesium element in the first sub-pixel. The second metal oxide pattern is prepared by following operations: applying the second metal oxide film on the side of the first light-emitting pattern away from the base substrate, a material of the second metal oxide film comprising an oxide precursor comprising the magnesium element; applying an intermediate layer with a photosensitive property on the side of the second metal oxide film away from the base substrate; exposing the second sub-pixel by using a mask to allow ultraviolet light to pass through the mask to expose the intermediate layer; dissolving an unexposed portion of the intermediate layer by using a developer to expose the oxide precursor comprising the magnesium element, and dissolving the exposed oxide precursor comprising the magnesium element by using a solvent; and performing a high-temperature annealing process on the second sub-pixel, and forming the second metal oxide pattern by crystallizing the oxide precursor comprising the magnesium element in the second sub-pixel.

In some embodiments, the forming a patterned metal oxide layer on the base substrate, comprises: forming the patterned metal oxide layer on the base substrate by magnetron sputtering or evaporation by using a fine metal mask.

### BRIEF DESCRIPTION OF THE DRAWINGS

In order to describe the technical solutions in the embodiments of the present disclosure more clearly, the drawings needed to be used in the embodiments will be briefly introduced below. Obviously, the drawings in the following description are only some embodiments of the present disclosure. Those of ordinary skill in the art can also obtain other drawings based on these drawings without undue experimentation.
Fig. 1 illustrates a partial structural diagram of an array substrate according to an embodiment of the present disclosure;
Fig. 2 illustrates a partial structural diagram of an array substrate according to another embodiment of the present disclosure;
Fig. 3 illustrates a structural diagram of a display device according to an embodiment of the present disclosure;
Fig. 4 illustrates a flow chart of a method of manufacturing an array substrate according to an embodiment of the present disclosure;
Fig. 5 illustrates a process schematic diagram of a method of manufacturing an array substrate according to an embodiment of the present disclosure; and
Fig. 6 illustrates the influence of metal oxide layers doped with different proportions of magnesium on the elution effect of the light-emitting layer.

### DETAILED DESCRIPTION OF THE DISCLOSURE

The technical solutions in the embodiments of the present disclosure will be clearly described below with reference to the accompanying drawings in the embodiments of the present disclosure. Obviously, the described embodiments are only some, but not all, of the embodiments of the present disclosure. Based on the embodiments in this disclosure, all other embodiments obtained by those of ordinary skill in the art without undue experimentation fall within the scope of protection of the present disclosure.

Quantum dot light-emitting diodes have become one of the most potential self-light-emitting display devices due to their advantages such as lower energy consumption, higher color purity, wider color gamut, higher stability, and longer fluorescence lifetime. The precise preparation of sub-pixel regions of quantum dot light-emitting diode display device is a prerequisite for realizing the high-resolution display device. The conventional manufacturing method of the quantum dot light-emitting layer is: forming a patterned photoresist by exposing and developing a photoresist layer, using the patterned photoresist to shield the quantum dot film, and etching the unnecessary portion to form a quantum dot light-emitting layer of the desired pattern. Such preparation method has a complicated process and requires a separate photoresist, resulting in high production costs.

The inventor(s) of the present application found that a quantum dot film with photosensitive property can be directly exposed and developed to form a patterned quantum dot light-emitting layer without using photoresist and without etching the quantum dot film. Such manufacturing method is simple and low-cost. However, the inventor(s) found that during preparing the quantum dot display device, due to the weak bonding force between the quantum dot film and the base (the quantum dot film is applied on the surface of the base), when a developer is used to develop the quantum dot film with photosensitive property, not only the quantum dot film in the non-target area can be peeled off from the substrate, but also the quantum dot film in the target area can be peeled off or damaged from the substrate, making the quantum dot film unable to reproduce the pattern of the mask well, and resulting in the inability to prepare a patterned quantum dot light-emitting layer with high quality and the inability to realize a quantum dot light-emitting diode display device with high resolution.

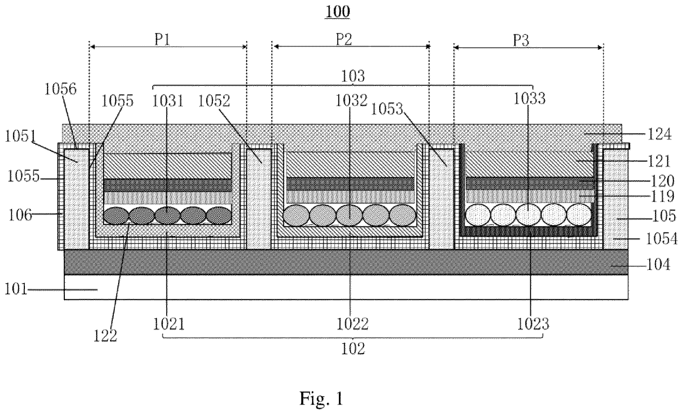

In order to solve the problems existing in the related art, embodiments of the present disclosure provide an array substrate. Fig. 1 illustrates a partial structural diagram of an array substrate 100. The array substrate 100 comprises: a base substrate 101, a patterned metal oxide layer 102 and a patterned light-emitting layer 103. The base substrate 101 comprises a plurality of sub-pixels arranged in an array. As an example, Fig. 1 only illustrates three adjacent sub-pixels, i.e., the first sub-pixel P1, the second sub-pixel P2, and the third sub-pixel P3. However, as known by those skilled in the art, the base substrate 101 actually comprises more sub-pixels, and these sub-pixels are arranged in multiple rows and multiple columns. The metal oxide layer 102 is located on the base substrate 101 and is located in the plurality of sub-pixels. The metal oxide layer 102 comprises at least one of magnesium element and calcium element, and a portion of the metal oxide layer 102 located in any one of the plurality of sub-pixels is spaced apart from a portion of the metal oxide layer 102 located in another sub-pixel adjacent to the any one sub-pixel. Fig. 1 illustrates that the metal oxide layer 102 comprises a first metal oxide pattern 1021, a second metal oxide pattern 1022, and a third metal oxide pattern 1023. The first metal oxide pattern 1021 is located in the first sub-pixel P1, the second metal oxide pattern 1022 is located in the second sub-pixel P2, and the third metal oxide pattern 1023 is located in the third sub-pixel P3. The first metal oxide pattern 1021 located in the first sub-pixel P1 is spaced apart from the second metal oxide pattern 1022 located in the second sub-pixel P2, and the second metal oxide pattern 1022 located in the second sub-pixel P2 is spaced apart from the third metal oxide pattern 1023 located in the third sub-pixel P3. The patterned light-emitting layer 103 is located on a side of the metal oxide layer 102 away from the base substrate 101 and is located in the plurality of sub-pixels. Fig. 1 illustrates that the light-emitting layer 103 comprises a first light-emitting pattern 1031, a second light-emitting pattern 1032, and a third light-emitting pattern 1033. The first light-emitting pattern 1031 is located in the first sub-pixel P1, the second light-emitting pattern 1032 is located in the second sub-pixel P2, and the third light-emitting pattern 1033 is located in the third sub-pixel P3. The light-emitting layer 103 comprises a photosensitive material and is in contact with the metal oxide layer 102.

It should be noted that the phrase "the light-emitting layer 103 comprises a photosensitive material" does not mean that the finished product light-emitting layer 103 has photosensitive property, rather, it means that the presence of the photosensitive material causes a light-emitting layer film (the light-emitting layer 103 is formed by patterning the light-emitting layer film) to have photosensitive property during preparation. The term "photosensitive property" refers to a photochemical reaction occurs in the photosensitive material in the light-emitting layer film under exposure to specific wavelengths (such as ultraviolet light), resulting in changes in the chemical composition of the exposed or unexposed regions of the light-emitting layer film. The light-emitting layer film may be a positive glue type or a negative glue type. During the preparation process, the chemical composition of the portion of the light-emitting layer film that is exposed to a specific wavelength changes, while the chemical composition of the portion of the light-emitting layer film that is not exposed does not change. If the exposed portion can be dissolved in a specific developer and the unexposed portion cannot be dissolved by the developer, the light-emitting layer film is the positive glue type light-emitting layer film. On the contrary, if the unexposed portion can be dissolved in a specific developer and the exposed portion cannot be dissolved by the developer, the light-emitting layer film is the negative glue type light-emitting layer film. This means that during preparation, the light-emitting layer film with photosensitive property can be directly exposed and developed to form the patterned light-emitting layer 103 without using photoresist and without etching the light-emitting layer film.

The light-emitting layer 103 is in direct contact with the metal oxide layer 102. Since the metal oxide layer 102 comprises at least one of magnesium element and calcium element, through experiments, it was found that the presence of magnesium element and/or calcium element will enhance the bonding force between the light-emitting layer 103 and the metal oxide layer 102, so that the two are firmly bonded. During the preparation of the light-emitting layer 103, the light-emitting layer film in the target region is not peeled off from the surface of the metal oxide layer 102 by the developer, but is firmly bonded to the surface of the metal oxide layer 102. Therefore, in the array substrate 100, the first light-emitting pattern 1031 of the light-emitting layer 103 is firmly bonded to the first metal oxide pattern 1021 of the metal oxide layer 102 and positioned in the first sub-pixel P1, the second light-emitting pattern 1032 of the light-emitting layer 103 is firmly bonded to the second metal oxide pattern 1022 of the metal oxide layer 102 and positioned in the second sub-pixel P2, and the third light-emitting pattern 1033 of the light-emitting layer 103 is firmly bonded to the third metal oxide pattern 1023 of the metal oxide layer 102 and positioned in the third sub-pixel P3. Compared with the related art, the array substrate 100 provided by the embodiments of the present disclosure enhances the interaction force between the light-emitting layer 103 and the metal oxide layer 102 by changing the element composition of the metal oxide layer 102. Therefore, the light-emitting layer film in the target sub-pixel region will not be peeled off from the surface of the metal oxide layer 102 by the developer during development, and the light-emitting layer 103 can well copy the pattern of the mask and be accurately patterned. When such an array substrate 100 is used in a display device, it helps to realize a display device with high resolution.

In some embodiments, the material of the metal oxide layer 102 comprises magnesium. In some embodiments, the material of the metal oxide layer 102 comprises calcium. In some embodiments, the material of the metal oxide layer 102 comprises magnesium and calcium.

The material of the metal oxide layer 102 may comprise oxide nanoparticles comprising magnesium element. The surface of the oxide nanoparticles comprising magnesium element may have photosensitive ligand molecules. It should be noted that in this application, the term "photosensitive ligand molecule" may mean that the ligand molecule has photosensitive property; or, may mean that the ligand molecule does not have photosensitive property, but the ligand molecule is a product of the molecules with photosensitive property after reaction. Whether a photosensitive ligand molecule has photosensitive property depends on its state. If the photosensitive ligand molecules are mentioned in the finished device, since the photosensitive ligand molecules have already undergone exposure and chemical reactions in the early preparation stage, the photosensitive ligand molecules in the finished device refer to the product of the molecules with photosensitive property after reaction in the preparation stage, and the product has no photosensitive property. If the photosensitive ligand molecules are mentioned during the preparation of the magnesium-comprising oxide, the photosensitive ligand molecules are formed on the surface of the magnesium-comprising oxide by ligand exchange or in-situ grafting, the photosensitive ligand molecules have photosensitive property and will undergo chemical reactions under irradiation of specific wavelength.

In some embodiments, the structural formula of the oxide nanoparticles with photosensitive ligand molecules on its surface is 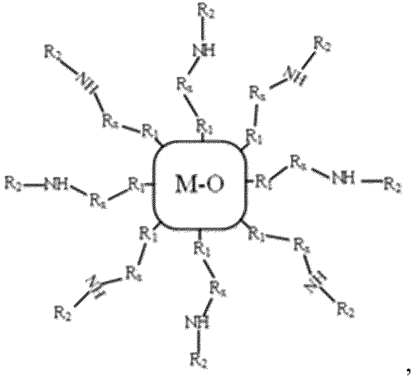 where M-O represents the oxide nanoparticle comprising the magnesium element, 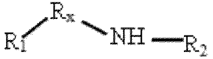 represents the photosensitive ligand molecule, R₁ is selected from one of hydroxyl, sulfydryl, amino, carbonyl, carboxyl and ester group, R₂ is selected from one of hydrogen atom, methyl, ethyl, propyl and isopropyl, and Rₓ is an aliphatic alkane chain with 1 to 6 carbon atoms. In some embodiments, the structural formula of the oxide nanoparticle comprising the magnesium element is 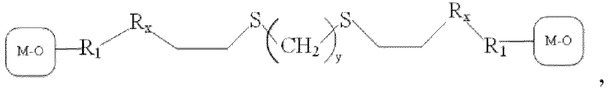 the surface of the oxide nanoparticle having the photosensitive ligand molecules, where M-O represents the oxide nanoparticle comprising the magnesium element, 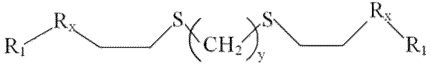 represents the photosensitive ligand molecule between two adjacent oxide nanoparticles comprising the magnesium element, R₁ is selected from one of hydroxyl, sulfydryl, amino, carbonyl, carboxyl and ester group, Rₓ is an aliphatic alkane chain with 1 to 18 carbon atoms or a carbon molecular chain, a main chain of the carbon molecular chain comprises one of nitrogen atom, oxygen atom, and sulfur atom, 1≤y≤18. The presence of photosensitive ligand molecules allows the patterned metal oxide layer 102 to be prepared by exposure and development. The specific preparation method will be introduced in detail later, and will not be described in detail here.

In some embodiments, the array substrate 100 may further comprise ruptured microcapsules 122 located between the base substrate 101 and the light-emitting layer 103 and exposing the metal oxide layer 102. The material of the microcapsule 122 comprises a macromolecular material having at least one side chain, and the side chain comprises a reversible chemical bond. During preparation, the reversible chemical bond of the side chain can cause bond formation and bond breaking of the functional groups of the side chain under certain conditions (such as irradiation or heating). The ruptured microcapsules 122 in the array substrate 100 are trace and are intermediate products remaining in the process of the array substrate 100. During the manufacture of the array substrate 100, microcapsules are used to encapsulate metal oxides (for example, the metal oxides may be oxide nanoparticles or microcrystals comprising magnesium). Under ultraviolet light irradiation or heating, the microcapsules in the target region rupture to expose the oxide nanoparticles or microcrystals comprising magnesium, so as to achieve patterning of the oxide nanoparticles or microcrystals comprising magnesium, thereby forming the patterned metal oxide layer 102. The specific preparation method will be introduced in detail later, and will not be described in detail here.

In some embodiments, the material of the metal oxide layer 102 comprises crystals comprising magnesium element. The crystal may be obtained by an oxide precursor through high-temperature annealing. The degree of crystallization of the oxide precursor is related to the annealing temperature during preparation. If the annealing temperature is high, the degree of crystallization of the oxide precursor will be high, for example, the degree of crystallization may be close to 100%. If the annealing temperature is low, the degree of crystallization of the oxide precursor will be low, but the degree of crystallization will also be higher than 50%. Compared with the metal oxide layer 102 formed of nanoparticles or microcrystals, the molecular arrangement in the crystalline metal oxide layer is relatively denser.

The materials of the metal oxide layer 102 comprising magnesium element comprise but are not limited to: magnesium oxide (MgO), magnesium zinc oxide (ZnMgO), magnesium oxide (MgO) or magnesium zinc oxide (ZnMgO) doped with metal elements such as aluminum (Al), gallium (Ga), tin (Sn), indium (In), titanium (Ti), and a mixture of two or more of these substances. The content of magnesium element in the metal oxide layer 102 is greater than or equal to 1.5%, the phrase "the content of magnesium element in the metal oxide layer 102" refers to the percentage of the molar amount of magnesium element in the metal oxide layer 102 to the sum of molar amounts of all metal elements in the metal oxide layer 102. For example, assuming that the metal oxide layer 102 is ZnO doped with Mₓ metal element and Mg metal element, the content of magnesium element in the metal oxide layer 102 = the molar amount of Mg element / (the molar amount of Mg element + the molar amount of Mₓ element + the molar amount of Zn element) * 100%. In embodiments of the present disclosure, the thickness of the metal oxide layer 102 is less than or equal to 100 nm, such as less than or equal to 90 nm, less than or equal to 80 nm, less than or equal to 60 nm, and so on. The upper limit of the content of magnesium element in the metal oxide layer 102 is related to the thickness of the metal oxide layer 102. When the thickness of the metal oxide layer 102 is less than or equal to 8 nm, the maximum value of the content of magnesium element in the metal oxide layer 102 is 1.5%~100%, when it is 100%, it means that the metal oxide layer 102 is MgO. When the thickness of the metal oxide layer 102 is greater than or equal to 8 nm, the maximum value of the content of magnesium element in the metal oxide layer 102 is 1.5%~40%. In an example, the thickness of the metal oxide layer 102 is greater than or equal to 15 nm and less than or equal to 60 nm, and the maximum value of the content of magnesium element in the metal oxide layer 102 is 2%~20%, for example, 5%~20%, 10%~20%, etc.

When the material of the metal oxide layer 102 is ZnO doped with Mg element, ZnO is usually used as an electron transport material in the device. Doping magnesium element in ZnO will widen the band gap, but if magnesium element is doped too much, the electron transport effect will be affected. Therefore, when the thickness of the metal oxide layer 102 is relatively thick, for example, greater than or equal to 8~10 nm, the content of magnesium element in the metal oxide layer 102 should be controlled in a lower range, and the maximum value of the content of magnesium element cannot be higher than 40%. When the thickness of the metal oxide layer 102 is relatively thin, for example, between 1~8 nm, since the thickness has no obvious effect on electron transmission, the metal oxide layer 102 can be doped with a higher content of magnesium element, for example, the maximum value of the content of magnesium element can reach 100%. The introduction of magnesium element into the metal oxide layer 102 can help improve the efficiency and lifetime of the light-emitting device under the conditions of an appropriate doping ratio of the magnesium element and an appropriate thickness of the metal oxide layer 102. In addition, as mentioned above, the introduction of magnesium element into the metal oxide layer 102 helps to improve the adhesion between the metal oxide layer 102 and the light-emitting layer 103. The content of magnesium element in the metal oxide layer 102 is related to the adhesion between the metal oxide layer 102 and the light-emitting layer 103. When within an appropriate range, the higher content of the magnesium element in the metal oxide layer 102, the greater the adhesion between the metal oxide layer 102 and the light-emitting layer 103.

It should be noted that in the array substrate 100, the portions of the metal oxide layer 102 located in different sub-pixels may have the same magnesium doping amount or may have different magnesium doping amounts, the embodiments of the present disclosure do not specifically limit this. For example, the magnesium doping amount of the first metal oxide pattern 1021 located in the first sub-pixel P1, the magnesium doping amount of the second metal oxide pattern 1022 located in the second sub-pixel P2, and the magnesium doping amount of the third metal oxide pattern 1023 located in the third sub-pixel P3, their values may be the same, may be different from each other, or may be partially the same. In this way, the proportion of magnesium element in the metal oxide layer 102 in the sub-pixels can be adjusted according to the characteristics of the light-emitting layers in different sub-pixels (such as the red light-emitting layer, the green light-emitting layer, the blue light-emitting layer, etc.), the carrier injection of sub-pixels emitting different colors can thus be controlled respectively, which is beneficial to more accurately control the light-emitting performance of the array substrate 100.

Referring to Fig. 1, the plurality of sub-pixels comprise a plurality of first sub-pixels P1, a plurality of second sub-pixels P2 and a plurality of third sub-pixels P3. The light-emitting layer 103 comprises a plurality of first light-emitting patterns 1031, a plurality of second light-emitting patterns 1032, and a plurality of third light-emitting patterns 1033. Ideally, it is desired that only the first light-emitting pattern 1031 exists in the first sub-pixel P1 of the array substrate 100 without the second light-emitting pattern 1032 and the third light-emitting pattern 1033, only the second light-emitting pattern 1032 exists in the second sub-pixel P2 without the first light-emitting pattern 1031 and the third light-emitting pattern 1033, and only the third light-emitting pattern 1033 exists in the third sub-pixel P3 without the first light-emitting pattern 1031 and the second light-emitting pattern 1032. However, limited by factors such as process conditions and equipment accuracy, in actual products, the target sub-pixel is allowed to be provided with a target light-emitting pattern and a trace amount of non-target light-emitting pattern. For example, it is allowed that the first sub-pixel P1 is mainly provided with the first light-emitting pattern 1031 and is residual a trace amount of the second light-emitting pattern 1032 and the third light-emitting pattern 1033, as long as the residual amounts of the second light-emitting pattern 1032 and the third light-emitting pattern 1033 are controlled within a reasonable range so that human eyes cannot detect the color mixing of the emitted light.

The first sub-pixel P1 comprises a main first light-emitting pattern 1031 and a trace amount of the second light-emitting pattern 1032 and/or the third light-emitting pattern 1033. Similarly, the second sub-pixel P2 comprises a main second light-emitting pattern 1032 and a trace amount of the first light-emitting pattern 1031 and/or the third light-emitting pattern 1033. The third sub-pixel P3 comprises a main third light-emitting pattern 1033 and a trace amount of the first light-emitting pattern 1031 and/or the second light-emitting pattern 1032. The material of the light-emitting layer 103 is quantum dots. In some embodiments, the number of quantum dots of the second light-emitting pattern 1032 and/or the third light-emitting pattern 1033 residual in a unit area of the first sub-pixel P1 is 0~500 pcs/µm², for example, 0~10 pcs/µm², 0~50 pcs/µm², 0~80 pcs/µm², 0.5~85 pcs/µm². The number of quantum dots of the first light-emitting pattern 1031 and/or the third light-emitting pattern 1033 residual in a unit area of the second sub-pixel P2 is 0~500 pcs/µm², for example, 0~10 pcs/µm², 0~50 pcs/µm², 0~80 pcs/µm², 0.5~85 pcs/µm². The number of quantum dots of the first light-emitting pattern 1031 and/or the second light-emitting pattern 1032 residual in a unit area of the third sub-pixel P3 is 0~500 pcs/µm², for example, 0~10 pcs/µm², 0~50 pcs/µm², 0~80 pcs/µm², 0.5~85 pcs/µm². In some embodiments, the first light-emitting pattern 1031 is configured to emit light of a first color, such as red light, the second light-emitting pattern 1032 is configured to emit light of a second color, such as green light, and the third light-emitting pattern 1033 is configured to emit light of a third color, such as blue light.

The array substrate 100 provided by the embodiment of the present disclosure can effectively improve the problem of residual light-emitting patterns. Taking the first light-emitting pattern 1031 in Fig. 1 as an example, when preparing the first light-emitting pattern 1031, since at this stage, only the first metal oxide pattern 1021 in the first sub-pixel P1 is formed in the array substrate 100 while the second metal oxide pattern 1022 in the second sub-pixel P2 and the third metal oxide pattern 1023 in the third sub-pixel P3 have not been formed, after the light-emitting layer film is applied on the first metal oxide pattern 1021, the portion of the light-emitting layer film located in the first sub-pixel P1 is in direct contact with the first metal oxide pattern 1021 comprising magnesium element, and the two have a strong bonding force; while the portions of the light-emitting layer film located in other regions are in direct contact with the base that does not comprise magnesium element, so the two have weak bonding force. Therefore, when the light-emitting layer film is developed by a developer, the portions of the light-emitting layer film located in other regions are easily eluted from the base, while the portion of the light-emitting layer film located in the first sub-pixel P1 cannot be eluted by the developer, so that the first light-emitting pattern 1031 is basically only formed in the first sub-pixel P1, and a trace amount of the first light-emitting pattern 1031 remains in other regions (such as the second sub-pixel P2 and the third sub-pixel P3). For similar reasons, a trace amount of the second light-emitting pattern 1032 and the third light-emitting pattern 1033 are residual in the non-target pixels.

By detecting the spectrum emitted by the array substrate 100, it is found that the spectrometer can basically detect no impurity peaks in the spectrum emitted from the array substrate 100. For example, when the red sub-pixel is turned on, the spectrometer only detects the red peak; when the green sub-pixel is turned on, the spectrometer only detects the green peak; and when the blue sub-pixel is turned on, the spectrometer only detects the blue peak. Even if there is occasional residue, the peak value of the impurity peak detected by the spectrometer does not exceed five thousandths of the peak value of the original main color spectrum. This shows that the remaining amount of the light-emitting pattern in the non-target sub-pixels in the array substrate 100 of the embodiments of the present disclosure is basically negligible.

Continuing to refer to Fig. 1, the array substrate 100 further comprises an electrode layer 104 located between the base substrate 101 and the metal oxide layer 102. The material of the electrode layer 104 may be any suitable material, comprising but not limited to Al, Ag, Au, Mo, Ti, ITO, IZO, IGZO, etc. In some embodiments, the metal oxide layer 102 is in direct contact with the surface of the electrode layer 104 away from the base substrate 101, that is, there is no other intermediate layer (such as the electron transport layer) between the metal oxide layer 102 and the electrode layer 104. In this case, the metal oxide layer 102 also has the function of electron transport. In an alternative embodiment, the array substrate 100 comprises an electrode layer 104 between the base substrate 101 and the metal oxide layer 102 and an electron transport layer 106 between the electrode layer 104 and the metal oxide layer 102, that is, the metal oxide layer 102 and the electron transport layer 106 are two independent layers. The material of the electron transport layer 106 may be any suitable electron transport material that does not comprise magnesium, such as ZnO, SnO, TiO, GaO, AlO, or an oxide doped with two or more metal elements, such as ZnGaO, ZnSnO, ZnTiO, ZnAlO, SnGaO, ZnInO, ZnSnGaO, etc. In some embodiments, the material of the electron transport layer 106 is an electron transport material that does not comprise magnesium element, the material of the metal oxide layer 102 is MgO, and the ratio of the thickness of MgO to the thickness of the electron transport layer 106 is 1:80-1:1. The thickness of the electron transport layer 106 is 8nm~80nm, and the thickness of MgO is 1nm~8nm. When the thickness of MgO is 1 nm and the thickness of the electron transport layer 106 is 80 nm, the ratio of the thickness of MgO to the thickness of the electron transport layer 106 is 1:80. When the thickness of MgO is 8 nm and the thickness of the electron transport layer 106 is 8 nm, the ratio of the thickness of MgO to the thickness of the electron transport layer 106 is 1:1. The array substrate 100 may further comprise a pixel defining layer 105 located on the base substrate 101 and located in a region between any two adjacent sub-pixels of the plurality of sub-pixels. Fig. 1 illustrates four pixel defining portions of the pixel defining layer 105, which are respectively a first pixel defining portion 1051, a second pixel defining portion 1052, a third pixel defining portion 1053, and a fourth pixel defining portion 1054. The second pixel defining portion 1052 is located between the first sub-pixel P1 and the second sub-pixel P2, and the third pixel defining portion 1053 is located between the second sub-pixel P2 and the third sub-pixel P3. Each pixel defining portion comprises a sidewall and a top surface on a side away from the base substrate 101. Taking the first pixel defining portion 1051 as an example, it comprises a sidewall 1055 and a top surface 1056. In some embodiments, the electron transport layer 106 is a continuous layer that is not only disposed within multiple sub-pixels but also covers the top surface of the pixel defining layer 105 away from the base substrate 101 and all sidewalls. In an alternative embodiment, the electron transport layer 106 may also be a patterned layer. In some embodiments, the metal oxide layer 102 is only disposed at the bottom of the sub-pixel and does not cover the pixel defining layer 105. In an alternative embodiment, the metal oxide layer 102 is not only disposed within the sub-pixel but also covers the sidewalls of the pixel defining layer 105, but does not cover the top surface of the pixel defining layer 105 away from the base substrate 101. As mentioned before, the metal oxide layer 102 is not a continuous layer, but a patterned layer, and adjacent patterns are separated by the pixel defining layer 105. For example, the first metal oxide pattern 1021 of the metal oxide layer 102 covers the sidewalls of the first pixel defining portion 1051 and the second pixel defining portion 1052 facing the first sub-pixel P1, but does not cover the top surfaces of the first pixel defining portion 1051 and the second pixel defining portion 1052 away from the base substrate 101; the second metal oxide pattern 1022 of the metal oxide layer 102 covers the sidewalls of the second pixel defining portion 1052 and the third pixel defining portion 1053 facing the second sub-pixel P2, but does not cover the top surfaces of the second pixel defining portion 1052 and the third pixel defining portion 1053 away from the base substrate 101, the first metal oxide pattern 1021 is spaced apart from the second metal oxide pattern 1022 through the second pixel defining portion 1052; the third metal oxide pattern 1023 of the metal oxide layer 102 covers the sidewalls of the third pixel defining portion 1053 and the fourth pixel defining portion 1054 facing the third sub-pixel P3, but does not cover the top surfaces of the third pixel defining portion 1053 and the fourth pixel defining portion 1054 away from the base substrate 101, the second metal oxide pattern 1022 is spaced apart from the third metal oxide pattern 1023 through the third pixel defining portion 1053. In still some alternative embodiments, the metal oxide layer 102 is not only disposed within the sub-pixel, but also covers the sidewalls of the pixel defining layer 105 and a part of the top surface of the pixel defining layer 105 away from the base substrate 101. For example, the first metal oxide pattern 1021 covers the sidewalls of the first pixel defining portion 1051 and the second pixel defining portion 1052 facing the first sub-pixel P1 and a part of the top surfaces of the first pixel defining portion 1051 and the second pixel defining portion 1052 away from the base substrate 101; the second metal oxide pattern 1022 covers the sidewalls of the second pixel defining portion 1052 and the third pixel defining portion 1053 facing the second sub-pixel P2 and a part of the top surfaces of the second pixel defining portion 1052 and the third pixel defining portion 1053 away from the base substrate 101; and the third metal oxide pattern 1023 covers the sidewalls of the third pixel defining portion 1053 and the fourth pixel defining portion 1054 facing the third sub-pixel P3 and a part of the top surfaces of the third pixel defining portion 1053 and the fourth pixel defining portion 1054 away from the base substrate 101. In some embodiments, the orthographic projection of the light-emitting layer 103 on the base substrate 101 substantially overlaps with the orthographic projection of the metal oxide layer 102 on the base substrate 101. "Substantially overlapping" means that the orthographic projection of the light-emitting layer 103 on the base substrate 101 does not exceed the orthographic projection of the metal oxide layer 102 on the base substrate 101. In some embodiments, the orthographic projection of the light-emitting layer 103 on the base substrate 101 falls within the orthographic projection of the metal oxide layer 102 on the base substrate 101. In an alternative embodiment, the orthographic projection of the light-emitting layer 103 on the base substrate 101 overlaps with the orthographic projection of the metal oxide layer 102 on the base substrate 101.

In some embodiments, the material of the light-emitting layer 103 may be quantum dots. Quantum dots comprise, but are not limited to, CdS, CdSe, ZnSe, ZnTeSe, InP, PbS, CsPbCl₃, CsPbBr₃, CsPhI₃, CdS/ZnS, CdSe/ZnS, ZnSe, ZnSeTe, InP/ZnS, PbS/ZnS, CsPbCl₃/ZnS, CsPbBr₃ /ZnS, CsPhI₃/ZnS, CdS/ZnSeS/ZnS, CdSe/ZnSeS/ZnS, ZnSe/ZnSeS/ZnS, ZnSeTe/ZnSeS/ZnS, InP/ZnS, PbS/ZnS, CsPbCl₃/ZnS, CsPbBr₃/ZnS, CsPhI₃/ZnS. In an embodiment where the material of the light-emitting layer 103 is quantum dots, the shape of the quantum dots may be any geometric shape such as a sphere, an ellipsoid, a polyhedron, a rod, a cross, a ring, etc. The quantum dot film used to form the light-emitting layer 103 may be a quantum dot film with photosensitive property. By exposing the quantum dot film, a photochemical reaction occurs in the exposed portion or the unexposed portion of the quantum dot film to induce cross-linking, then the cross-linked portions are dissolved and removed by using a developer, thereby forming the patterned light-emitting layer 103.

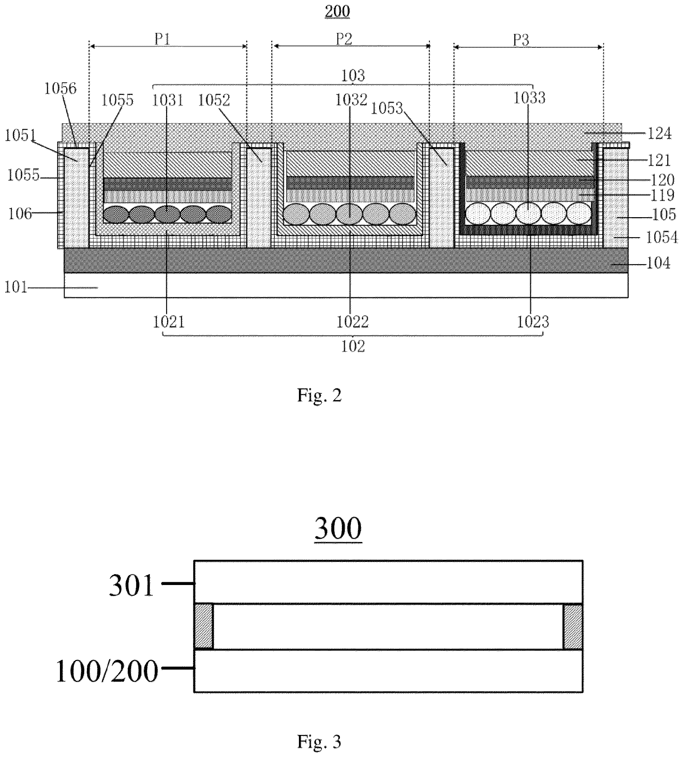

Fig. 2 illustrates an array substrate 200 provided according to another embodiment of the present disclosure. The array substrate 200 comprises: a base substrate 101 comprising a plurality of sub-pixels arranged in an array; a first electrode layer 104 located on the base substrate 101; a pixel defining layer 105 located on the base substrate 101 and between any two adjacent sub-pixels among the plurality of sub-pixels, the pixel defining layer 105 comprising a sidewall and a top surface away from the base substrate 101; an electron transport layer 106 located on a side of the first electrode layer 104 away from the base substrate 101, the electron transport layer 106 being arranged in the plurality of sub-pixels and covering the sidewalls and top surface of the pixel defining layer 105; a patterned metal oxide layer 102 located on a side of the electron transport layer 106 away from the base substrate 101, the metal oxide layer 102 being arranged in the plurality of sub-pixels, alternatively, the metal oxide layer 102 may cover the sidewalls and/or a part of the top surface of the pixel defining layer 105, the portion of the metal oxide layer 102 located in any one of the plurality of sub-pixels being spaced apart from the portion of the metal oxide layer 102 located in another sub-pixel adjacent to the any one sub-pixel by the pixel defining layer 105, and the metal oxide layer 102 comprising at least one of magnesium element and calcium element; a patterned light-emitting layer 103 located on a side of the metal oxide layer 102 away from the base substrate 101 and located in the plurality of sub-pixels; a hole transport layer 119 located on a side of the light-emitting layer 103 away from the base substrate 101; a hole injection layer 120 located on a side of the hole transport layer 119 away from the base substrate 101; and a second electrode layer 121 located on a side of the hole injection layer 120 away from the base substrate 101.

Fig. 2 illustrates four pixel defining portions of the pixel defining layer 105, which are respectively a first pixel defining portion 1051, a second pixel defining portion 1052, a third pixel defining portion 1053, and a fourth pixel defining portion 1054. The second pixel defining portion 1052 is located between the first sub-pixel P1 and the second sub-pixel P2, and the third pixel defining portion 1053 is located between the second sub-pixel P2 and the third sub-pixel P3. Each pixel defining portion comprises a sidewall and a top surface on a side away from the base substrate 101. Taking the first pixel defining portion 1051 as an example, it comprises a sidewall 1055 and a top surface 1056. In some embodiments, the electron transport layer 106 is a continuous layer that is not only disposed within multiple sub-pixels but also covers the top surface of the pixel defining layer 105 away from the base substrate 101 and all sidewalls. In some embodiments, the metal oxide layer 102 is not only disposed within the sub-pixel but also covers the sidewalls of the pixel defining layer 105, but does not cover the top surface of the pixel defining layer 105 away from the base substrate 101. As mentioned before, the metal oxide layer 102 is not a continuous layer, but a patterned layer, and adjacent patterns are separated by the pixel defining layer 105. For example, the first metal oxide pattern 1021 of the metal oxide layer 102 covers the sidewalls of the first pixel defining portion 1051 and the second pixel defining portion 1052 facing the first sub-pixel P1, but does not cover the top surfaces of the first pixel defining portion 1051 and the second pixel defining portion 1052 away from the base substrate 101; the second metal oxide pattern 1022 of the metal oxide layer 102 covers the sidewalls of the second pixel defining portion 1052 and the third pixel defining portion 1053 facing the second sub-pixel P2, but does not cover the top surfaces of the second pixel defining portion 1052 and the third pixel defining portion 1053 away from the base substrate 101, the first metal oxide pattern 1021 is spaced apart from the second metal oxide pattern 1022 through the second pixel defining portion 1052; the third metal oxide pattern 1023 of the metal oxide layer 102 covers the sidewalls of the third pixel defining portion 1053 and the fourth pixel defining portion 1054 facing the third sub-pixel P3, but does not cover the top surfaces of the third pixel defining portion 1053 and the fourth pixel defining portion 1054 away from the base substrate 101, the second metal oxide pattern 1022 is spaced apart from the third metal oxide pattern 1023 through the third pixel defining portion 1053.

The metal oxide layer 102 comprises at least one of magnesium element and calcium element. Through experiments, it was found that the presence of magnesium element and/or calcium element makes the metal oxide layer 102 have a strong bonding force with the light-emitting layer film subsequently formed on the metal oxide layer 102, and prevents the light-emitting layer film in the target region from being peeled off from the surface of the metal oxide layer 102 by the developer, which is beneficial to forming the patterned light-emitting layer 103 with high quality. Furthermore, the patterned design of the metal oxide layer 102 is conducive to the subsequent formation of the patterned light-emitting layer 103 with high precision on the surface of the metal oxide layer 102, which greatly reduces the difficulty of patterning the light-emitting layer solely by relying on light-emitting materials.

In some embodiments, the material of the electron transport layer 106 is an electron transport material that does not comprise magnesium element, the material of the metal oxide layer 102 is MgO, and the ratio of the thickness of MgO to the thickness of the electron transport layer 106 is 1:80-1:1. The thickness of the electron transport layer 106 is 8nm~80nm, and the thickness of MgO is 1nm~8nm. When the thickness of MgO is 1 nm and the thickness of the electron transport layer 106 is 80 nm, the ratio of the thickness of MgO to the thickness of the electron transport layer 106 is 1:80. When the thickness of MgO is 8 nm and the thickness of the electron transport layer 106 is 8 nm, the ratio of the thickness of MgO to the thickness of the electron transport layer 106 is 1:1.

Fig. 3 illustrates a schematic structural diagram of a display device 300 provided according to another embodiment of the present disclosure. The display device 300 comprises: the array substrate 100 or the array substrate 200 described according to any of the previous embodiments; and a counter substrate 301 opposite to the array substrate 100 or 200. The display device 300 may be any product or component with the display function, such as a mobile phone, a tablet computer, a television, a monitor, a notebook computer, a digital photo frame, a navigator, or the like. In some embodiments, the display device 300 is a quantum dot light-emitting diode (QLED) display device. Compared with the traditional organic light-emitting diode display devices, the QLED display device has better color purity, better contrast and stronger stability.

The display device 300 may have substantially the same technical effect as the array substrate 100 or 200 described in the previous embodiments, and for the purpose of brevity, the technical effect of the display device 300 will not be repeated here.

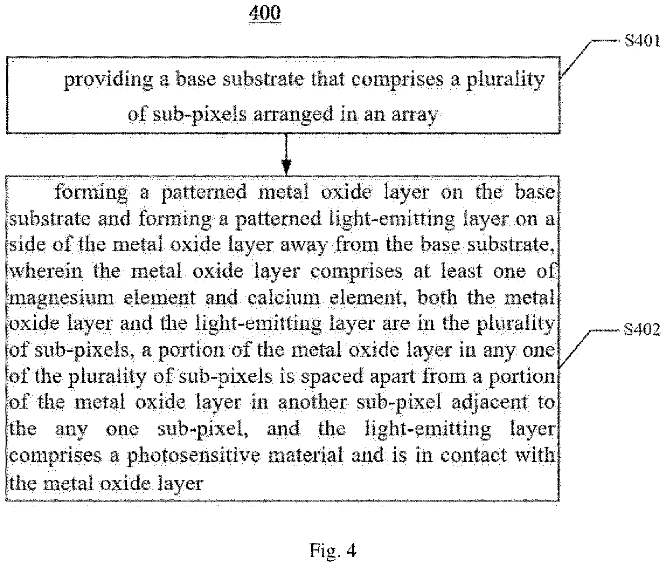

Fig. 4 illustrates a flow chart of a method 400 for manufacturing an array substrate according to another embodiment of the present disclosure. Next, the method 400 is described with reference to Figs. 1 and 4.

S401: providing a base substrate 101 which comprises a plurality of sub-pixels arranged in an array. The base substrate 101 may be made of flexible or rigid material. Specifically, the base substrate 101 may be PEN resin, silicone resin, polyimide, glass, quartz, plastic, etc., the embodiments of the present disclosure do not limit the material of the base substrate 101. The plurality of sub-pixels may comprise a plurality of first sub-pixels P1, a plurality of second sub-pixels P2 and a plurality of third sub-pixels P3. The first sub-pixel P1 may be, for example, a red sub-pixel configured to emit red light, the second sub-pixel P2 may be, for example, a green sub-pixel configured to emit green light, and the third sub-pixel P3 may be, for example, a blue sub-pixel configured to emit blue light.

S402: forming a patterned metal oxide layer 102 on the base substrate 101 and forming a patterned light-emitting layer 103 on a side of the metal oxide layer 102 away from the base substrate 101. The metal oxide layer 102 comprises at least one of magnesium element and calcium element, both the metal oxide layer 102 and the light-emitting layer 103 are located in the plurality of sub-pixels, and a portion of the metal oxide layer 102 located in any one of the plurality of sub-pixels is spaced apart from a portion of the metal oxide layer 102 located in another sub-pixel adjacent to the any one sub-pixel. Furthermore, the light-emitting layer 103 comprises a photosensitive material and is in contact with the metal oxide layer 102.

The light-emitting layer 103 is in direct contact with the metal oxide layer 102. Since the metal oxide layer 102 comprises at least one of magnesium element and calcium element, through experiments, it was found that the presence of magnesium element and/or calcium element enhances the bonding force between the light-emitting layer 103 and the metal oxide layer 102, so that the two are firmly bonded. During the preparation of the light-emitting layer 103, the light-emitting layer film in the target region is not peeled off from the surface of the metal oxide layer 102 by the developer, but is firmly bonded to the surface of the metal oxide layer 102. Compared with the related art, the method 400 provided by the embodiment of the present disclosure enhances the interaction force between the light-emitting layer 103 and the metal oxide layer 102 by changing the elemental composition of the metal oxide layer 102, so that the light-emitting layer film in the target sub-pixel region is not peeled off from the surface of the metal oxide layer 102 by the developer during development. The light-emitting layer 103 can well copy the pattern of the mask and be accurately patterned, which helps to realize a display device with high resolution.

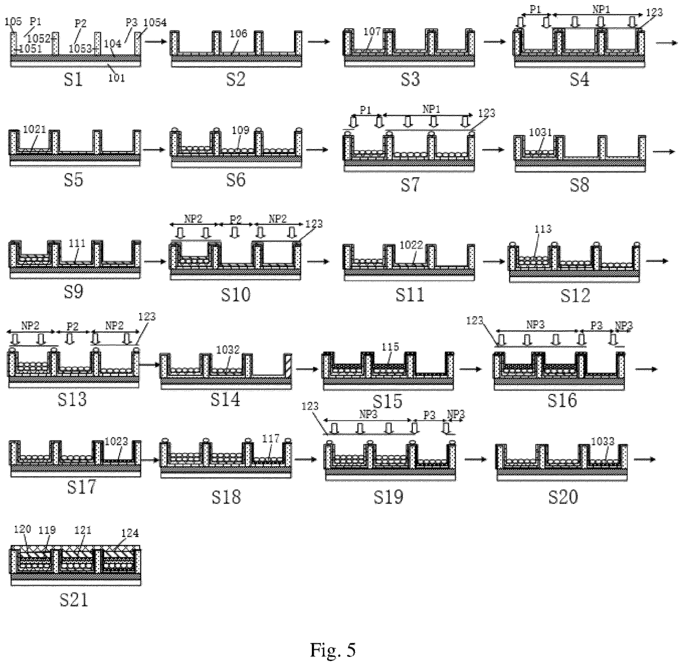

Referring to Fig. 5, several different manufacturing methods of the array substrate 100 or 200 will be described in several specific embodiments. The array substrate 100 or 200 formed by different methods has basically the same structure, and the difference between these methods mainly lies in the preparation method of the metal oxide layer 102. It should be noted that, as mentioned above, the material used to form the light-emitting layer 103 may be a positive glue type light-emitting material or a negative glue type light-emitting material. For ease of description, the embodiments of the present disclosure take the negative glue type light-emitting material as an example to describe the manufacturing method of the light-emitting layer, but this does not exclude the possibility that it is a positive glue type light-emitting material.
(I) The metal oxide layer 102 is formed of the oxide nanoparticles or microcrystals comprising magnesium, the oxide nanoparticles or microcrystals have photosensitive ligands.

Next, a method 500 for manufacturing an array substrate is described with reference to Fig. 5. The method 500 may comprise the following steps:
S1: providing a base substrate 101, and forming an electrode layer 104 and a pixel defining layer 105 on the base substrate 101. The electrode layer 104 may be a continuous layer deposited on the surface of the base substrate 101. The material of the electrode layer 104 may be any suitable material, comprising but not limited to Al, Ag, Au, Mo, Ti, ITO, IZO, IGZO, etc. The pixel defining layer 105 is used to define the sub-pixels, and the pixel defining layer 105 is located in a region between any two adjacent sub-pixels of the plurality of sub-pixels. The plurality of sub-pixels may comprise a plurality of first sub-pixels P1, a plurality of second sub-pixels P2, and a plurality of third sub-pixels P3.
S2: forming an electron transport layer 106 on a side of the electrode layer 104 away from the base substrate 101. The material of the electron transport layer 106 may be any suitable electron transport material without magnesium, such as ZnO, SnO, TiO, GaO, AlO, or an oxide doped with two or more metal elements, such as ZnGaO, ZnSnO, ZnTiO, ZnAlO, SnGaO, ZnInO, ZnSnGaO, etc. Since the electron transport layer 106 does not comprise magnesium, the light-emitting material subsequently formed on its surface has a weak bonding force to the electron transport layer 106, and the light-emitting material can be easily peeled off from the surface of the electron transport layer 106 by using a developer. The electron transport layer 106 is a continuous layer that is not only formed within the plurality of sub-pixels but also covers the pixel defining layer 105, such as covers the top surface of the pixel defining layer 105 away from the base substrate 101 and all sidewalls. In some embodiments, the electron transport layer 106 is nanoparticles formed by a spin method or a sol-gel method. In still another embodiment, the electron transport layer 106 is a flat film formed by a sputtering method. In an alternative embodiment, the step S2 may be omitted, that is, the preparation of the electron transport layer 106 may be omitted, and the step S1 can be directly jumped to the step S3. In this case, the electron transport layer 106 is not comprised in the array substrate, that is, its thickness is zero.
S3: applying a metal oxide film 107 on a side of the electron transport layer 106 away from the base substrate 101 by methods such as spin coating, blade coating, drop coating, spray coating, inkjet printing, etc. If the electron transport layer 106 is not comprised in the array substrate, the metal oxide film 107 is deposited on the side of the electrode layer 104 away from the base substrate 101. In this embodiment, the metal oxide film 107 may be oxide nanoparticles or microcrystals comprising the magnesium, the surfaces of the oxide nanoparticles or microcrystals have the photosensitive ligands. Materials of the oxide nanoparticles or microcrystals comprising the magnesium may be MgO, ZnMgO, MgO or ZnMgO doped with metal elements such as Al, Ga, Sn, In, Ti, etc., or a mixture of two or more of the above-mentioned substances. The thickness of the metal oxide film 107 is less than or equal to 100 nm. The content of magnesium element in the metal oxide film 107 needs to be greater than or equal to 1.5%. When the thickness of the metal oxide film 107 is less than or equal to 8 nm, the maximum value of the content of magnesium element in the metal oxide film 107 is 1.5%∼100%; when the thickness of the metal oxide film 107 is greater than or equal to 8 nm, the maximum value of the content of magnesium element in the metal oxide film 107 is 1.5%~40%.

The specific preparation method of oxide nanoparticles or microcrystals comprising the magnesium is described below, the surfaces of the oxide nanoparticles or microcrystals having the photosensitive ligands.

In some embodiments, the photosensitive ligand molecule may have the following structural formula (1):

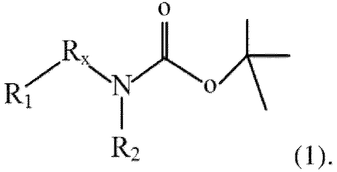

This photosensitive ligand molecule is hereinafter referred to as the photosensitive ligand molecule 1. Where, R₁ may be any one of hydroxyl, sulfydryl, amino, carbonyl, carboxyl and ester group, R₂ may be any one of hydrogen atom, methyl, ethyl, propyl, and isopropyl, Rₓ may be an aliphatic alkane chain with 1~6 carbon atoms, for example, Rₓ may be methylene, ethylene, propyl (n-propyl, isopropyl), butyl (n-butyl/isobutyl/neobutyl), pentyl (n-pentyl/isopentyl/neopentyl), hexyl (n-hexyl /isohexyl/new hexyl), and the like. A part of the structural formulas of Rₓ is illustrated in the figure below. It should be noted that in various embodiments of the present disclosure, "*" in the molecular structural formula represents other groups connected to the molecular structural formula. For example, 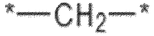 means that the left side of CH₂ is connected to a group(s), and the right side of CH₂ is connected to another group(s).

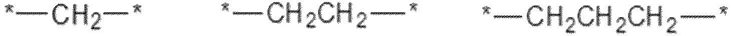

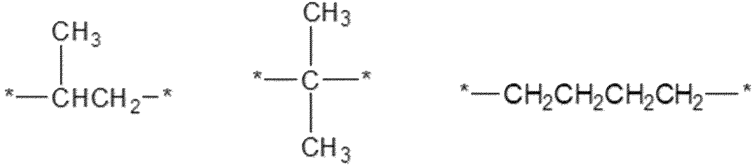

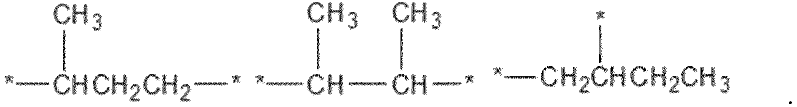

In some embodiments, the photosensitive ligand molecule 1 may be a commercially available ligand molecule material as illustrated below. It should be noted that these are only some of the possible materials listed, but the photosensitive ligand molecule 1 is not limited to the molecular materials listed below.

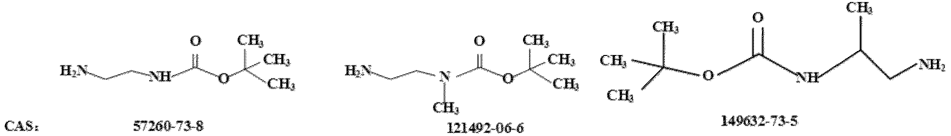

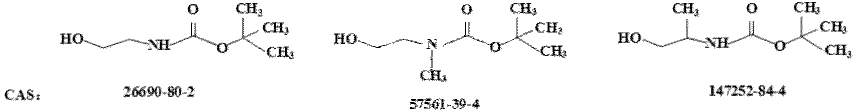

After the oxide nanoparticles which comprise magnesium and whose surfaces have the photosensitive ligand molecules 1 are mixed with a photoacid generator (PAG), the mixture is exposed to ultraviolet light of a specific wavelength, and the following reaction will occur:

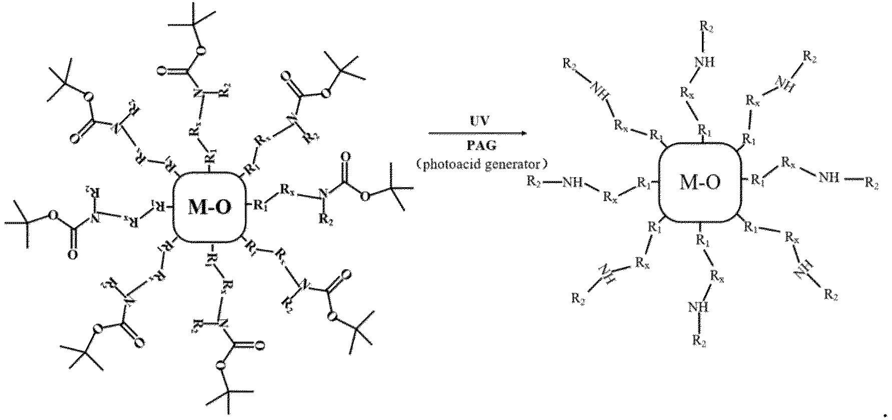

In the above molecular structural formula, "M-O" represents the oxide nanoparticle comprising the magnesium.

In a special case, if the oxide nanoparticles which comprise magnesium and whose surfaces have the photosensitive ligand molecules 1 are mixed with a larger amount of photoacid generator (PAG), under exposure to ultraviolet light of a specific wavelength, the larger amount of PAG will "strip and remove" the ligand molecules 1 on the surface of the oxide nanoparticles comprising magnesium, thereby forming a bare oxide nanoparticle comprising magnesium. The reaction is as follows:

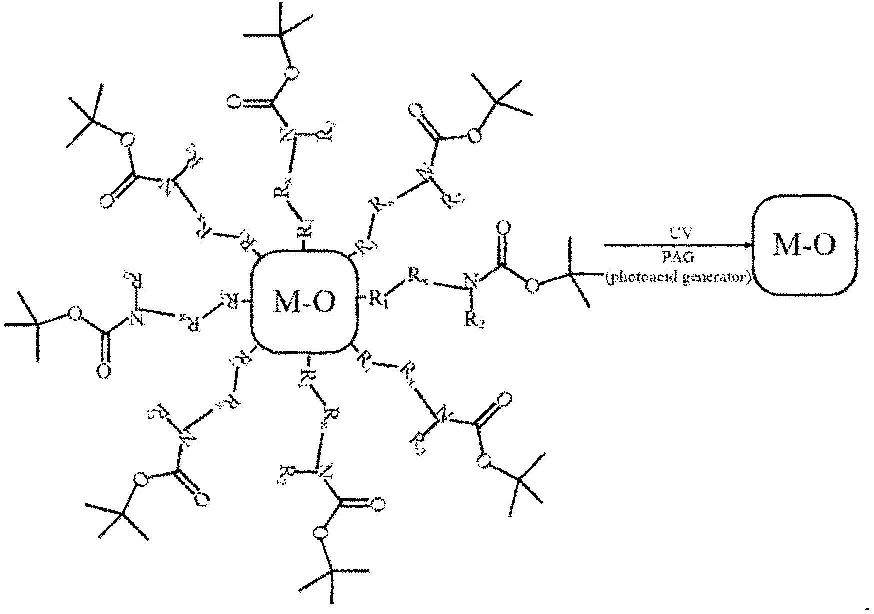

In alternative embodiments, the photosensitive ligand molecule may have the following structural formula (2):

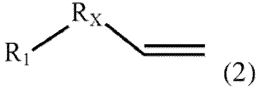

This photosensitive ligand molecule is hereinafter referred to as the photosensitive ligand molecule 2, in which R₁ may be any one of hydroxyl, sulfydryl, amino, carbonyl, carboxyl and ester group, and Rₓ may be any one of the following two situations:
(1) Rₓ may be an aliphatic alkane chain (comprising the linear chain type and the branched chain type) with 1~18 carbon atoms, comprising but not limited to methyl, ethyl, propyl (n-propyl, isopropyl), butyl (n-butyl/isobutyl/neobutyl), pentyl (n-pentyl/isopentyl/neopentyl), hexyl (n-hexyl/isohexyl/neohexyl), and the like. The following are examples of some of the structural formulas of Rₓ: 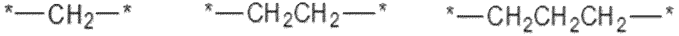 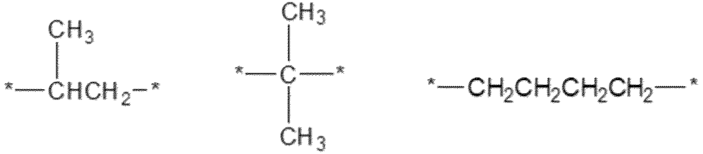 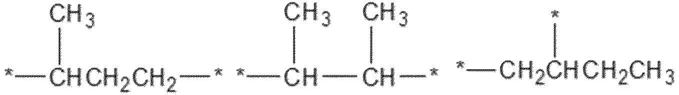
(2) Rₓ may be a carbon molecular chain whose main chain comprises atoms such as nitrogen, oxygen, sulfur, etc., for example 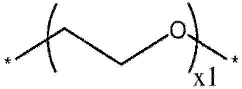 or 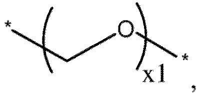 the O atoms in the main chain may be replaced by S atoms or N atoms. The number of repeating units x₁ should satisfy 1≤x₁≤9. Regarding the limitation of the value of x1, it is mainly considered that the molecular chain of the ligand molecule of the oxide comprising magnesium should not be too long, because an excessively long molecular chain of the ligand molecule will cause an undesirable change in properties of the surface of the oxide comprising magnesium.

In some embodiments, the photosensitive ligand molecule 2 may be a commercially available ligand molecule material as illustrated below. It should be noted that these are only some of the possible materials listed, but the photosensitive ligand molecule 2 is not limited to the molecular materials listed below.

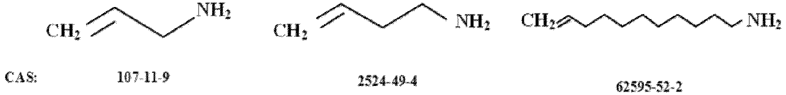

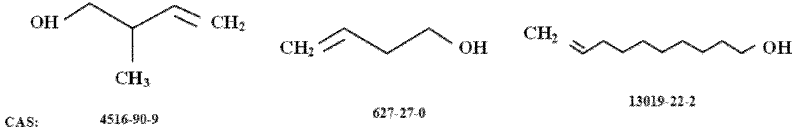

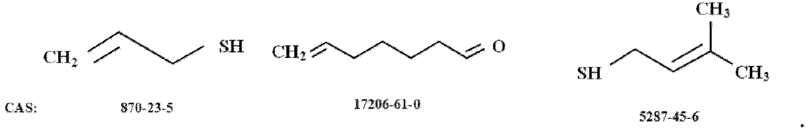

When the surface of the oxide comprising magnesium is the photosensitive ligand molecule 2, in order to further enhance the photosensitive cross-linking effect, in some embodiments, any one of the following (a) or (b) may be added to the system of the photosensitive ligand molecule 2:
(a) a small molecular chain with double sulfhydryl groups 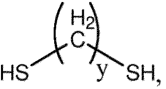 where y satisfies 1≤y≤18.
   Under the ultraviolet light irradiation condition, the following reaction occurs: 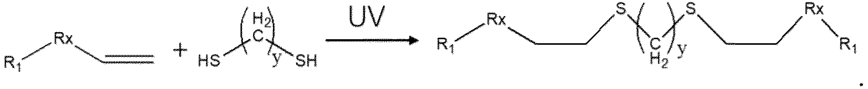
(b) a photosensitive initiator molecule, that is, a molecule which is capable of generating free radicals under UV light and initiates cross-linking between olefin groups. The reaction mechanism is as follows:

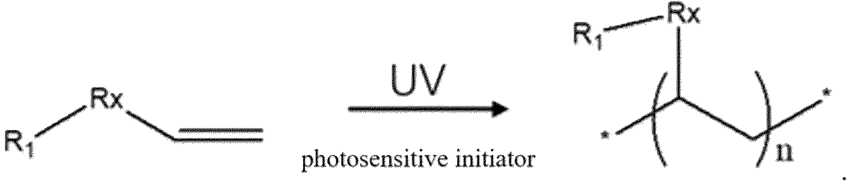

Two different types of photosensitive ligand molecules are described above. The surfaces of the oxide nanoparticles comprising magnesium can be provided with the above-mentioned photosensitive ligand molecules through in-situ grafting or ligand exchange. The methods of in-situ grafting and ligand exchange are described below in two specific examples.

### In-situ grafting method

The oxide nanoparticles comprising magnesium take Zn₁₋ₓMgₓO as an example, where the value of x may be 5%. The method for forming the photosensitive ligand molecule 1 on the surface of Zn₁₋ₓMgₓO may be: for example, 32.2 mg of magnesium acetate tetrahydrate and 625.6 mg of zinc acetate dihydrate are dissolved in 30-40 mL of dimethyl sulfoxide (DMSO) to form a mixed solution, and the mixed solution is transferred to a three-necked flask and stirred. Then, 10 mL of tetramethylammonium hydroxide methanol solution (the concentration may be 100 mg/mL) is added dropwise into the mixed solution and react at 30°C for about 60 minutes. After the reaction is completed, 100~300 µL of the above-mentioned photosensitive ligand molecule 1 is added dropwise and stirred thoroughly, to form magnesium zinc oxide nanoparticles whose surfaces have the photosensitive ligand molecules 1. The nanoparticles are precipitated and centrifuged in a suitable solvent such as propylene glycol methyl ether acetate, and then redissolved in a solvent such as ethanol or toluene to finally form a solution of the magnesium zinc oxide nanoparticles whose surfaces have the photosensitive ligand molecules 1.

### Ligand exchange method

The oxide nanoparticles comprising magnesium take traditional alcohol-soluble magnesium zinc oxide nanoparticles as an example. The specific method for forming the photosensitive ligand molecule 1 or 2 on the surface of magnesium zinc oxide nanoparticles may be: the solvent (which is usually an alcohol solvent, such as the ethanol) in 5 mL of magnesium zinc oxide nanoparticle solution (the concentration of the solution may be, for example, 20 mg/mL) is drained by, for example, rotary evaporation, and then 5 mL of toluene or chloroform solvent is added, at this time, the magnesium zinc oxide nanoparticles cannot be dissolved in the solvent. Then, 1mL~2mL of the above-mentioned photosensitive ligand molecules 1 or 2 are added and stirred thoroughly until the magnesium zinc oxide nanoparticles are re-dissolved in the solvent. In this case, the ligands exchange sufficiently. Then, the solution is added drop by drop into a methanol solution whose volume is 10 times of the solution, precipitated and centrifuged, and then the precipitate is re-dissolved in a solvent such as toluene, to form a solution of magnesium zinc oxide nanoparticles whose surfaces have the photosensitive ligand molecules 1 or 2.

The above describes the preparation method of oxide nanoparticles whose surfaces have the photosensitive ligand molecules. As described in step S3, the oxide nanoparticle solution is deposited on the surface of the electron transport layer 106 to form the metal oxide film 107.

S4: aligning a mask 123 with the array substrate so that the mask 123 exposes the first sub-pixel P1 and blocks the non-target region NP1 (comprising the second sub-pixel P2 and the third sub-pixel P3), and irradiating the metal oxide film 107 with ultraviolet light. In the embodiment of the present disclosure, for convenience of description, the metal oxide film 107 is taken as a negative glue type material (that is, the exposed portion is not dissolved in the developer, and the unexposed portion is dissolved in the developer). However, this does not exclude the possibility that the metal oxide film 107 is a positive glue type material.

S5: developing the metal oxide film 107 which has been exposed to the ultraviolet light by a developer, so that the metal oxide film 107 in the non-target region NP1 is eluted, and the metal oxide film 107 in the first sub-pixel P1 is retained. After the development is completed, processes such as thermal baking annealing are performed, thereby forming a patterned first metal oxide pattern 1021 in the first sub-pixel P1. The first metal oxide pattern 1021 is located within the first sub-pixel P1, and may cover the sidewalls of the first pixel defining portion 1051 and the second pixel defining portion 1052 facing the first sub-pixel P1 but does not cover the top surfaces of the first pixel defining portion 1051 and the second pixel defining portion 1052 away from the base substrate 101.

In some embodiments, when the surfaces of the oxide nanoparticles comprising magnesium have the photosensitive ligand molecules 2, the chemical structural formula of the first metal oxide pattern 1021 which is formed through the above steps S3 to S5 may be: 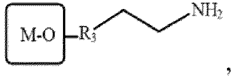 where, R₃ may be SH or NH₂. When R₃ is SH, the chemical structural formula of the first metal oxide pattern 1021 is 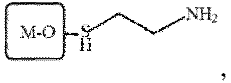 when R₃ is NH₂, the chemical structural formula of the first metal oxide pattern 1021 is 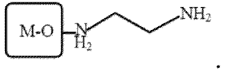 In alternative embodiments, when the surfaces of the oxide nanoparticles comprising magnesium have the photosensitive ligand molecules 2, the chemical structural formula of the first metal oxide pattern 1021 which is formed through the above steps S3 to S5 may be: 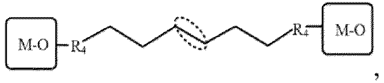 where, "M-O" represents the oxide nanoparticle comprising magnesium element, 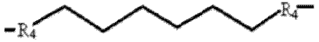 represents the combined photosensitive ligand formed by cross-linking the photosensitive ligands on the surfaces of two adjacent oxide nanoparticles comprising magnesium element, the dotted ellipse represents the cross-linking site of two photosensitive ligand molecules, R₄ may be OH or SH. When R₄ is OH, the chemical structural formula of the first metal oxide pattern 1021 is 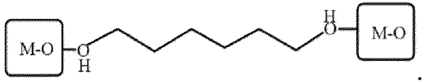 When R₄ is SH, the chemical structural formula of the first metal oxide pattern 1021 is

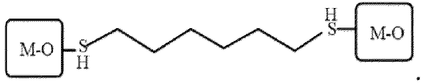

S6: depositing a light-emitting layer film 109 on the surface of the first metal oxide pattern 1021 away from the base substrate 101 and on the surface of the exposed electron transport layer 106 away from the base substrate 101. During the deposition process, the light-emitting layer film 109 is also deposited on the sidewalls of the pixel defining layer 105 and on the top surfaces of the pixel defining portions 1051-1054 away from the base substrate 101. In some embodiments, the light-emitting layer film 109 may be quantum dots. The quantum dots may be any suitable quantum dot material that can be patterned by photolithography, comprising but not limited to quantum dot materials that can cross-link after irradiation.

S7: using the mask 123 to expose the first sub-pixel P1 and block the non-target region NP1, and using ultraviolet light to illuminate the light-emitting layer film 109. The exposed portion of the light-emitting layer film 109 does not undergo a photochemical reaction and will not be dissolved in a specific developer, while the unexposed portion of the light-emitting layer film 109 undergoes a photochemical reaction and will be dissolved in a specific developer.

S8: developing the light-emitting layer film 109 which has been exposed to the ultraviolet light by a developer. Since the electron transport layer 106 does not comprise magnesium element, the light-emitting layer film 109 and the electron transport layer 106 have weak bonding force in the non-target region NP1, the developer can relatively easily and completely elute the light-emitting layer film 109 on the surface of the electron transport layer 106 in the non-target region NP1, and the light-emitting layer film 109 basically does not remain in the non-target region NP1 or remains little. In contrast, the first metal oxide pattern 1021 comprises magnesium element, as mentioned above, the magnesium element can enhance the bonding force between the first metal oxide pattern 1021 and the light-emitting layer film 109, therefore, no matter how strong the elution effect of the developer is, the developer will not elute or damage the light-emitting layer film 109 in the first sub-pixel P1. After the development is completed, processes such as thermal baking annealing are performed, thereby forming the first light-emitting pattern 1031 in the first sub-pixel P1. In some embodiments, the first light-emitting pattern 1031 may be configured to emit red light. In some embodiments, the first light-emitting pattern 1031 covers the sidewalls and top surfaces of the first pixel defining portion 1051 and the second pixel defining portion 1052. With the cooperation of the electron transport layer 106 that does not comprise magnesium element and the first metal oxide pattern 1021 that comprises magnesium element, the first light-emitting pattern 1031 is basically formed only in the first sub-pixel P1, and a very small amount of the first light-emitting pattern 1031 remains in the second sub-pixel P2 and the third sub-pixel P3. In some embodiments, the number of quantum dots of a second light-emitting pattern 1032 and/or a third light-emitting pattern 1033 that are residual in a unit area of the first sub-pixel P1 is 0~500 pcs/µm², for example, 0~10 pcs/µm², 0~50 pcs/µm², 0~80 pcs/µm², 0.5~85 pcs/µm².

S9: depositing a metal oxide film 111 on the side of the first light-emitting pattern 1031 and the exposed electron transport layer 106 away from the base substrate 101. The metal oxide film 111 may be oxide nanoparticles or microcrystals which comprise magnesium and whose surfaces have the photosensitive ligands. The preparation method of the oxide nanoparticles or microcrystals which comprise magnesium and whose surfaces have the photosensitive ligands may refer to the description of step S3. The material of the metal oxide film 111 and the material of the metal oxide film 107 may be the same or different. In addition, the content of magnesium element in the metal oxide film 111 and the content of magnesium element in the metal oxide film 107 may be exactly the same or may be different.

S10: aligning the mask 123 with the array substrate so that the mask 123 exposes the second sub-pixel P2 and blocks the non-target region NP2 (comprising the first sub-pixel P1 and the third sub-pixel P3), and irradiating the metal oxide film 111 with ultraviolet light.

S11: developing the metal oxide film 111 which has been exposed to the ultraviolet light by a developer, so that the metal oxide film 111 in the non-target region NP2 is eluted, and the metal oxide film 111 in the second sub-pixel P2 is retained. After the development is completed, processes such as thermal baking annealing are performed, thereby forming a patterned second metal oxide pattern 1022 in the second sub-pixel P2. The second metal oxide pattern 1022 is located within the second sub-pixel P2, and may cover the sidewalls of the second pixel defining portion 1052 and the third pixel defining portion 1053 facing the second sub-pixel P2, but does not cover the top surfaces of the second pixel defining portion 1052 and the third pixel defining portion 1053 away from the base substrate 101. The first metal oxide pattern 1021 is spaced apart from the second metal oxide pattern 1022 by the second pixel defining portion 1052.

S12: depositing a light-emitting layer film 113 on the surfaces of the first light-emitting pattern 1031, the second metal oxide pattern 1022, and the exposed electron transport layer 106 away from the base substrate 101. In some embodiments, the light-emitting layer film 113 may be quantum dots. The color of light emitted by the light-emitting layer film 113 is different from the color of light emitted by the light-emitting layer film 109.

S13: using the mask 123 to expose the second sub-pixel P2 and block the non-target region NP2, and using ultraviolet light to illuminate the light-emitting layer film 111. The exposed portion of the light-emitting layer film 111 does not undergo a photochemical reaction and will not be dissolved in a specific developer, while the unexposed portion of the light-emitting layer film 111 undergoes a photochemical reaction and will be dissolved in a specific developer.

S14: developing the light-emitting layer film 111 which has been exposed to the ultraviolet light by a developer. Since the first light-emitting pattern 1031 and the electron transport layer 106 do not comprise magnesium element, the light-emitting layer film 111 has weak bonding force with the first light-emitting pattern 1031 and the electron transport layer 106 that are in the non-target region NP2, the developer can relatively easily and completely elute the light-emitting layer film 111 in the non-target region NP2, and the light-emitting layer film 111 basically does not remain in the non-target region NP2 or remains little. In contrast, the second metal oxide pattern 1022 comprises magnesium element, as mentioned above, the magnesium element can enhance the bonding force between the second metal oxide pattern 1022 and the light-emitting layer film 111, therefore, no matter how strong the elution effect of the developer is, the developer will not elute or damage the light-emitting layer film 111 in the second sub-pixel P2. After the development is completed, processes such as thermal baking annealing are performed, thereby forming a second light-emitting pattern 1032 in the second sub-pixel P2. In some embodiments, the second light-emitting pattern 1032 may be configured to emit green light. In some embodiments, the second light-emitting pattern 1032 covers the sidewalls and top surfaces of the second pixel defining portion 1052 and the third pixel defining portion 1053. With the cooperation of the electron transport layer 106 and the first light-emitting pattern 1031 that do not comprise magnesium element as well as the second metal oxide pattern 1022 that comprises magnesium element, the second light-emitting pattern 1032 is basically formed only in the second sub-pixel P2, and a very small amount of the second light-emitting pattern 1032 remains in the first sub-pixel P1 and the third sub-pixel P3. In some embodiments, the number of quantum dots of the first light-emitting pattern 1031 and/or the third light-emitting pattern 1033 that are residual in a unit area of the second sub-pixel P2 is 0~500 pcs/µm², for example, 0~10 pcs/µm², 0~50 pcs/µm², 0~80 pcs/µm², 0.5~85 pcs/µm².

S15: depositing a metal oxide film 115 on the side of the first light-emitting pattern 1031, the second light-emitting pattern 1032 and the exposed electron transport layer 106 away from the base substrate 101. The metal oxide film 115 may be oxide nanoparticles or microcrystals which comprise magnesium and whose surfaces have the photosensitive ligands. The preparation method of the oxide nanoparticles or microcrystals which comprise magnesium and whose surfaces have the photosensitive ligands may refer to the description of step S3. The content of magnesium element in the metal oxide film 115 and the content of magnesium element in the metal oxide films 107 and 111 may be exactly the same or may be different.

S16: aligning the mask 123 with the array substrate so that the mask 123 exposes the third sub-pixel P3 and blocks the non-target region NP3 (comprising the first sub-pixel P1 and the second sub-pixel P2), and irradiating the metal oxide film 115 with ultraviolet light.

S17: developing the metal oxide film 115 which has been exposed to the ultraviolet light by a developer, so that the metal oxide film 115 in the non-target region NP3 is eluted, and the metal oxide film 115 in the third sub-pixel P3 is retained. After the development is completed, processes such as thermal baking annealing are performed, thereby forming a patterned third metal oxide pattern 1023 in the third sub-pixel P3. Until now, the patterned metal oxide layer 102 is formed. The third metal oxide pattern 1023 is located within the third sub-pixel P3, and may cover the sidewalls of the third pixel defining portion 1053 and the fourth pixel defining portion 1054 facing the third sub-pixel P3, but does not cover the top surfaces of the third pixel defining portion 1053 and the fourth pixel defining portion 1054 away from the base substrate 101. The second metal oxide pattern 1022 is spaced apart from the third metal oxide pattern 1023 by the third pixel defining portion 1053.

S18: depositing a light-emitting layer film 117 on the surfaces of the first light-emitting pattern 1031, the second light-emitting pattern 1032, and the third metal oxide pattern 1023 away from the base substrate 101. In some embodiments, the light-emitting layer film 117 may be quantum dots. The color of light emitted by the light-emitting layer film 117 is different from the color of light emitted by the light-emitting layer films 109 and 115.

S19: using the mask 123 to expose the third sub-pixel P3 and block the non-target region NP3, and using ultraviolet light to illuminate the light-emitting layer film 117. The exposed portion of the light-emitting layer film 117 does not undergo a photochemical reaction and will not be dissolved in a specific developer, while the unexposed portion of the light-emitting layer film 117 undergoes a photochemical reaction and will be dissolved in a specific developer.

S20: developing the light-emitting layer film 117 which has been exposed to the ultraviolet light by a developer. Since the first light-emitting pattern 1031 and the second light-emitting pattern 1032 do not comprise magnesium element, the light-emitting layer film 117 has weak bonding force with the first light-emitting pattern 1031 and the second light-emitting pattern 1032 in the non-target region NP3. Therefore, the developer can relatively easily and completely elute the light-emitting layer film 117 in the non-target region NP3, and the light-emitting layer film 117 basically does not remain in the non-target region NP3 or remains little. In contrast, the third metal oxide pattern 1023 comprises magnesium element, as mentioned above, the magnesium element can enhance the bonding force between the third metal oxide pattern 1023 and the light-emitting layer film 117, therefore, no matter how strong the elution effect of the developer is, the developer will not elute or damage the light-emitting layer film 117 in the third sub-pixel P3. After the development is completed, processes such as thermal baking annealing are performed, thereby forming a third light-emitting pattern 1033 in the third sub-pixel P3. Until now, the patterned light-emitting layer 103 is formed. The bonding force between the light-emitting layer 103 and the metal oxide layer 102 is greater than the bonding force between the light-emitting layer 103 and the base substrate 101. In some embodiments, the third light-emitting pattern 1033 covers the sidewalls and top surfaces of the third pixel defining portion 1053 and the fourth pixel defining portion 1054. In some embodiments, the third light-emitting pattern 1033 may be configured to emit blue light. With the cooperation of the first light-emitting pattern 1031 and the second light-emitting pattern 1032 that do not comprise magnesium element and the third metal oxide pattern 1023 that comprises magnesium element, the third light-emitting pattern 1033 is basically formed only in the third sub-pixel P3, and a very small amount of the third light-emitting pattern 1033 remains in the first sub-pixel P1 and the second sub-pixel P2. In some embodiments, the number of quantum dots of the first light-emitting pattern 1031 and/or the second light-emitting pattern 1032 that are residual in a unit area of the third sub-pixel P3 is 0~500 pcs/µm², for example, 0~10 pcs/µm², 0~50 pcs/µm², 0~80 pcs/µm², 0.5~85 pcs/µm².

S21: sequentially forming other functional layers on a side of the light-emitting layer 103 away from the base substrate 101, comprising but not limited to a hole transport layer 119, a hole injection layer 120, a second electrode layer 121, a light extraction layer (CPL) 124, and the like. The first electrode layer 104 may be a cathode, and the second electrode layer 121 may be an anode.

It should be noted that the various layers in Fig. 5 only represent the relative position and formation sequence, and do not represent the actual thickness ratio, shape or quantity. In addition, in order to avoid confusing the inventive concept of the embodiments of the present disclosure, only main steps are illustrated in the schematic diagram, and non-main process steps such as pre-baking, post-baking, annealing, cleaning, etc. are not illustrated in the diagram.

In some embodiments, the materials of the electrode layer 104, the electron transport layer 106, the first metal oxide pattern 1021, the first light-emitting pattern 1031, the hole transport layer 119, the hole injection layer 120, and the second electrode layer 121 in the first sub-pixel P1 may be ITO, ZnO, ZnMgO-1, RQD, TCTA (4, 4, 4-Tris(carbazole-9-yl) triphenylamine), MoOₓ, and Ag, respectively. The materials of the electrode layer 104, the electron transport layer 106, the second metal oxide pattern 1022, the second light-emitting pattern 1032, the hole transport layer 119, the hole injection layer 120, and the second electrode layer 121 in the second sub-pixel P2 may be ITO, ZnO, ZnMgO-2, GQD, TCTA, MoOₓ, and Ag, respectively. The materials of the electrode layer 104, the electron transport layer 106, the third metal oxide pattern 1023, the third light-emitting pattern 1033, the hole transport layer 119, the hole injection layer 120, and the second electrode layer 121 in the third sub-pixel P3 may be ITO, ZnO, ZnMgO-3, BQD, TCTA, MoOₓ, and Ag, respectively. In an embodiment, ZnMgO-1, ZnMgO-2, and ZnMgO-3 may be Zn_{0.95}Mg_{0.05}O, Zn_{0.92}Mg_{0.08}O, and Zn_{0.85}Mg_{0.15}O, respectively.

(II) The metal oxide layer 102 is formed of oxide nanoparticles or microcrystals that comprise magnesium and are wrapped by microcapsules with photosensitive or thermo-sensitive property.

Next, another method 600 for manufacturing the array substrate is described. Except for the preparation method of the metal oxide layer 102, the steps of the method 600 are basically the same as the steps of the method 500. For the sake of simplicity, only the differences from method 500 will be introduced in the following, and the similarities may refer to the description of method 500. The steps of method 600 are as follows:
S601: preparing the electrode layer 104 and the electron transport layer 106 by using the same method as steps S1-S2. Alternatively, the electron transport layer 106 may be omitted.
S602: applying the metal oxide film 107 on the side of the electron transport layer 106 away from the base substrate 101 by methods such as spin coating, blade coating, spray coating, etc. In this embodiment, the metal oxide film 107 is oxide nanoparticles or microcrystals that comprise magnesium and are wrapped by microcapsules with photosensitive or thermo-sensitive property. The microcapsule with photosensitive or thermo-sensitive property has the following characteristics: after being irradiated with ultraviolet light of a specific wavelength or heated to a certain temperature, the microcapsule opens or ruptures, thereby exposing the oxide nanoparticles or microcrystals that comprise magnesium and are wrapped inside the microcapsule.

The oxide nanoparticles or microcrystals that comprise magnesium and are wrapped by microcapsules with photosensitive or thermo-sensitive property can be prepared in advance. Microcapsules are usually made of macromolecular materials. Such macromolecules have at least one side chain, and the side chain has a functional group that can form bonds and break bonds under light or heating. In some embodiments, the structural formula of the microcapsule with photosensitive or thermo-sensitive property may be: 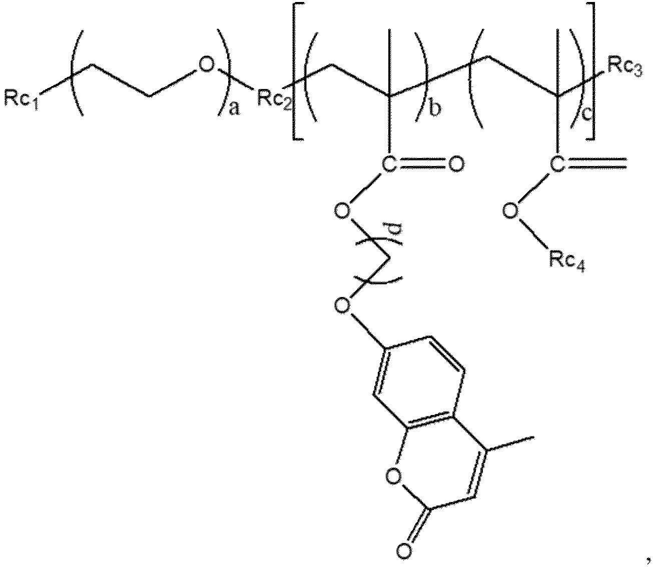 where Rc1 and Rc3 are hydrogen atoms or alkane groups, and Rc2 and Rc4 are alkane groups. When Rc1~Rc4 are alkane groups, the alkane groups may comprise but are not limited to: methyl, ethyl, propyl (n-propyl/isopropyl), butyl (n-butyl/isobutyl), pentyl (n-pentyl/isopentyl/neopentyl), hexyl (n-hexyl/isohexyl/neopentyl), and the like. a, b, c, and d should meet the following conditions:
(1) a≥60. The chain segment in the structural formula of the microcapsule 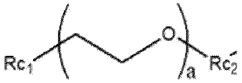 is a hydrophilic molecular segment, which provides hydrophilicity to the overall molecule. When dissolved in polar solvents (such as water, alcohols, DMSO, or their mixed solvents, etc.) to form micelle or microcapsule, the hydrophilic molecular segment forms the shell of the micelle or microcapsule, that is, the outer layer. Therefore, the molecular weight of the hydrophilic segment should be large enough, that is, the value of a is large enough to provide sufficient hydrophilicity for micelles and microcapsules.
(2) b+c≥30 and b≥16. The entire molecular chain segment within the square bracket in the structural formula of the microcapsule serves as a hydrophobic segment, which mainly provides hydrophobicity when forming the micelle in the above-mentioned polar solvents and forms the core portion of the micelle or microcapsule. The chain segment in the parentheses having the label b also provides the molecule with photosensitive properties of light cross-linking and light de-cross-linking.
(3) d may be any integer in the range of 1~20.

When the microcapsule is the photosensitive molecule, the molecule of the photosensitive microcapsule may undergo the following photosensitive reaction:

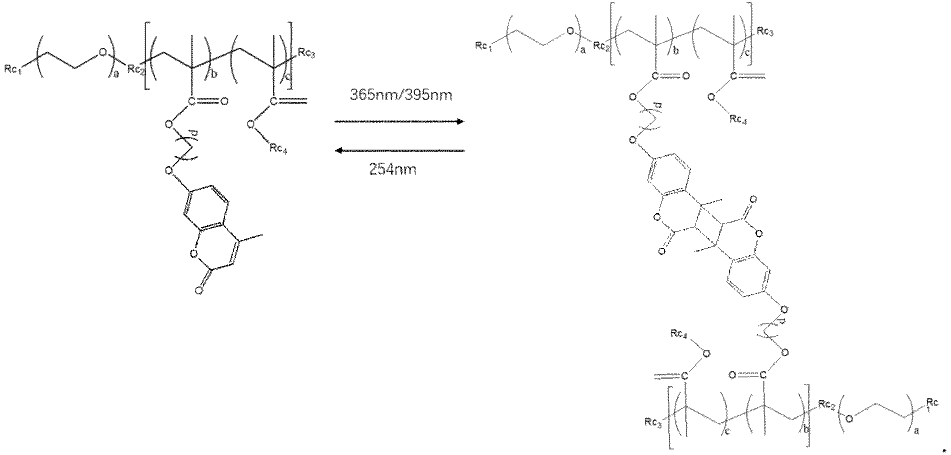

In a solution or dispersion (the solvent is a polar solvent) in which oxide nanoparticles or microcrystals comprising magnesium are dissolved or dispersed, the above-mentioned photosensitive microcapsule molecules are gradually added so that the microcapsule molecules form micelles in the solution or dispersion. A large number of micelles can wrap oxide comprising magnesium inside the micelles to form a stable colloidal system. After irradiation with ultraviolet light greater than 320 nm (such as 365 nm or 395 nm), the functional groups of the side chain of the microcapsule molecules form bonds, causing a cross-linking reaction in the core of the micelle. The oxide comprising magnesium wrapped inside the microcapsules can exist more stably in the microcapsules. The photosensitive microcapsules that wrap the oxide nanoparticles comprising magnesium can form the metal oxide film 107 as described above. The figure below illustrates a schematic diagram of the process of forming micellar microcapsules that wrap the oxide nanoparticles comprising magnesium, where "M-O" represents the oxide nanoparticle comprising magnesium.

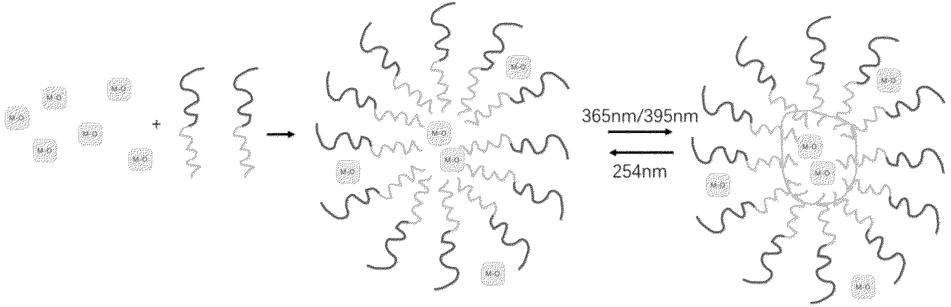

S603: aligning the mask 123 with the array substrate so that the mask 123 exposes the first sub-pixel P1 and blocks the non-target region NP1 (comprising the second sub-pixel P2 and the third sub-pixel P3), and using ultraviolet light less than 260 nm (for example, 254 nm) to irradiate the metal oxide film 107. Under the irradiation of ultraviolet light, the bonds of the functional group of the side chain of the microcapsule molecules are broken, and a de-cross-linking reaction occurs inside the microcapsule in the first sub-pixel P1, causing the microcapsule to rupture. The oxide nanoparticles comprising magnesium that are inside the microcapsules are exposed, so that the patterned first metal oxide pattern 1021 is formed in the first sub-pixel P1. Since the microcapsules in the non-target region NP1 are not exposed to ultraviolet light, the microcapsules in the non-target region NP1 still wrap the oxide nanoparticles comprising magnesium well. In some embodiments, the ruptured microcapsules in the first sub-pixel P1 may be left in the array substrate without any treatment, since the microcapsule itself can play the role of blocking electrons. The quantum dot light-emitting diode usually has more electrons and fewer holes, by blocking electron transmission, it helps to make the injection of carriers more balanced. In an alternative embodiment, a hydrophobic solvent or developer can be used for soaking or washing so as to wash away the remaining ruptured microcapsules in the first sub-pixel P1, so that the oxide comprising magnesium can be more fully exposed.

S604: performing steps S6-S8 according to the steps described in method 500 so as to form the first light-emitting pattern 1031 in the first sub-pixel P1.

S605: aligning the mask 123 with the array substrate so that the mask 123 exposes the second sub-pixel P2 and blocks the non-target region NP2 (comprising the first sub-pixel P1 and the third sub-pixel P3), and using ultraviolet light less than 260 nm (for example, 254 nm) to irradiate the metal oxide film 107 that has been deposited. Under the irradiation of ultraviolet light, a de-cross-linking reaction occurs inside the microcapsule in the second sub-pixel P2, causing the microcapsule to rupture, and the oxide nanoparticles comprising magnesium that are inside the microcapsules are exposed, so that the patterned second metal oxide pattern 1022 is formed in the second sub-pixel P2. Since the microcapsules in the third sub-pixel P3 are not exposed to ultraviolet light, the microcapsules in the third sub-pixel P3 still wrap the oxide nanoparticles comprising magnesium well. In some embodiments, the ruptured microcapsules in the second sub-pixel P2 may be left in the array substrate without any treatment. In an alternative embodiment, a hydrophobic solvent or developer can be used to wash away the remaining ruptured microcapsules in the second sub-pixel P2, so that the oxide comprising magnesium can be more fully exposed.

S606: performing steps S12-S14 according to the steps described in method 500 so as to form the second light-emitting pattern 1032 in the second sub-pixel P2.

S607: aligning the mask 123 with the array substrate so that the mask 123 exposes the third sub-pixel P3 and blocks the non-target region NP3 (comprising the first sub-pixel P1 and the second sub-pixel P2), and using ultraviolet light less than 260 nm (for example, 254 nm) to irradiate the metal oxide film 107 that has been deposited. Under the irradiation of ultraviolet light, a de-cross-linking reaction occurs inside the microcapsule in the third sub-pixel P3, causing the microcapsule to rupture, and the oxide nanoparticles comprising magnesium that are inside the microcapsules are exposed, so that the patterned third metal oxide pattern 1023 is formed in the third sub-pixel P3. In some embodiments, the ruptured microcapsules in the third sub-pixel P3 may be left in the array substrate without any treatment. In an alternative embodiment, a hydrophobic solvent or developer can be used to wash away the remaining ruptured microcapsules in the third sub-pixel P3, so that the oxide comprising magnesium can be more fully exposed. Until now, the patterned metal oxide layer 102 is formed.

S608: performing steps S18-S20 according to the steps described in method 500 so as to form the third light-emitting pattern 1033 in the third sub-pixel P3. Until now, the patterned light-emitting layer 103 is formed.

S609: sequentially forming the hole transport layer 119, the hole injection layer 120, the second electrode layer 121, and the light extraction layer (CPL) 124 according to the step S21 described in the method 500.

In some embodiments, the materials of the electrode layer 104, the electron transport layer 106, the first metal oxide pattern 1021, the first light-emitting pattern 1031, the hole transport layer 119, the hole injection layer 120, and the second electrode layer 121 in the first sub-pixel P1 may respectively be Ag+ITO, ZnO, ZnMgOx, RQD, TFB (Poly(9, 9-dioctylfluorene-alt-N-(4-secbutylphenyl)-diphenylamine)), MoOₓ, Ag+Mg. The materials of the electrode layer 104, the electron transport layer 106, the second metal oxide pattern 1022, the second light-emitting pattern 1032, the hole transport layer 119, the hole injection layer 120, and the second electrode layer 121 in the second sub-pixel P2 may respectively be Ag+ITO, ZnO, ZnMgOₓ, GQD, TFB, MoOₓ, Ag+Mg. The materials of the electrode layer 104, the electron transport layer 106, the third metal oxide pattern 1023, the third light-emitting pattern 1033, the hole transport layer 119, the hole injection layer 120, and the second electrode layer 121 in the third sub-pixel P3 may respectively be Ag+ITO, ZnO, ZnMgOₓ, BQD, TFB, MoOₓ, Ag+Mg.

In the method 600, the microcapsules wrapping the oxide nanoparticles or microcrystals comprising magnesium only need to be deposited once, and then the target regions are exposed sequentially at different time periods, so that the oxide nanoparticles comprising magnesium in different target regions are exposed sequentially, thus the metal oxide layer 102 is formed. For example, the microcapsules at the first sub-pixel P1 are first exposed, so that the oxide nanoparticles comprising magnesium that are wrapped inside the microcapsules are exposed to form the first metal oxide pattern 1021; then, after the first light-emitting pattern 1031 is prepared, the microcapsules at the second sub-pixel P2 are exposed, so that the oxide nanoparticles comprising magnesium that are wrapped inside the microcapsules are exposed to form the second metal oxide pattern 1022; then, after the second light-emitting pattern 1032 is prepared, the microcapsules at the third sub-pixel P3 are exposed, so that the oxide nanoparticles comprising magnesium that are wrapped inside the microcapsules are exposed to form the third metal oxide pattern 1023. The method 600 only needs to prepare the microcapsule layer once, and the steps are simple.

In the finished array substrate formed by the method 600, there are a small amount of microcapsule molecules, and the structural formula of these microcapsule molecules may be: 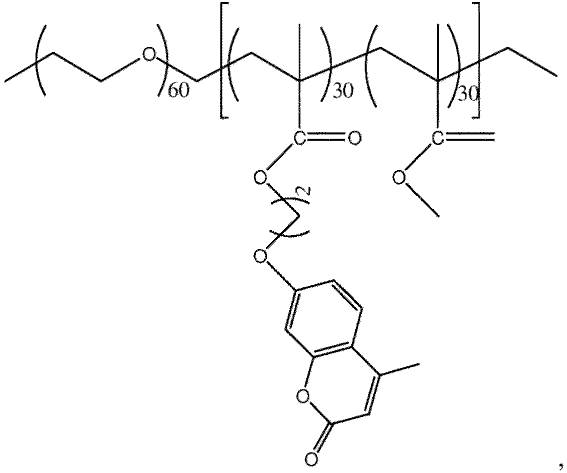 or/and

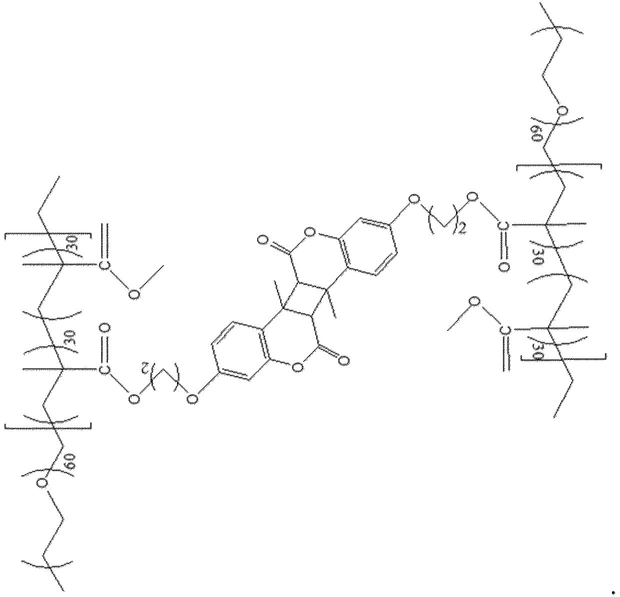

Next, another method 700 for manufacturing an array substrate is described. Except for the different processing methods for microcapsules in the non-target regions, the steps of the method 700 are basically the same as the steps of the method 600. That is, in this embodiment, before exposure, the oxide comprising magnesium is wrapped inside the microcapsule with the photosensitive property; after exposure, the microcapsule is ruptured, and the oxide comprising magnesium wrapped inside is exposed. For the sake of simplicity, only the differences from the method 600 will be introduced in the following. For similarities, please refer to the description of the method 600. The steps of the method 700 are as follows:
S701: preparing the electrode layer 104 and the electron transport layer 106 by using the same method as steps S1-S2. Alternatively, the electron transport layer 106 may be omitted.
S702: applying the metal oxide film 107 on the side of the electron transport layer 106 away from the base substrate 101 by methods such as spin coating, blade coating, spray coating, etc. In this embodiment, the metal oxide film 107 is oxide nanoparticles or microcrystals that comprise magnesium and are wrapped by microcapsules.
S703: aligning the mask 123 with the array substrate so that the mask 123 exposes the first sub-pixel P1 and blocks the non-target region NP1 (comprising the second sub-pixel P2 and the third sub-pixel P3), and using ultraviolet light less than 260 nm (for example, 254 nm) to irradiate the metal oxide film 107. Under the irradiation of ultraviolet light, a de-cross-linking reaction occurs inside the microcapsule in the first sub-pixel P1, causing the microcapsule to rupture. The oxide nanoparticles comprising magnesium that are inside the microcapsules are exposed, so that the patterned first metal oxide pattern 1021 is formed in the first sub-pixel P1. The microcapsules and the oxide nanoparticles comprising magnesium inside the microcapsules that are in the unexposed region NP1 are dissolved and removed by using a solvent or developer, and the ruptured microcapsules at the first sub-pixel P1 in the exposed region are dissolved and removed.
S704: performing steps S6-S8 according to the steps described in method 500 to form the first light-emitting pattern 1031 in the first sub-pixel P1.
S705: depositing a metal oxide film 111 on the side of the first light-emitting pattern 1031 and the exposed electron transport layer 106 away from the base substrate 101. The metal oxide film 111 is oxide nanoparticles or microcrystals that comprise magnesium and are wrapped by microcapsules. The content of the magnesium element in the metal oxide film 111 and the content of the magnesium element in the metal oxide film 107 may be the same or different. The mask 123 is aligned with the array substrate so that the mask 123 exposes the second sub-pixel P2 and blocks the non-target region NP2 (comprising the first sub-pixel P1 and the third sub-pixel P3), and the ultraviolet light less than 260 nm (for example, 254 nm) is used to irradiate the metal oxide film 111. Under the irradiation of ultraviolet light, a de-cross-linking reaction occurs inside the microcapsule in the second sub-pixel P2, causing the microcapsule to rupture. The oxide nanoparticles comprising magnesium that are inside the microcapsules are exposed, so that the patterned second metal oxide pattern 1022 is formed in the second sub-pixel P2. The microcapsules and the oxide nanoparticles comprising magnesium inside the microcapsules that are in the unexposed region NP2 are dissolved and removed by using a solvent or developer, and the ruptured microcapsules at the second sub-pixel P2 in the exposed region are dissolved and removed.
S706: performing steps S12-S14 according to the steps described in method 500 to form the second light-emitting pattern 1032 in the second sub-pixel P2.
S707: depositing a metal oxide film 115 on the side of the first light-emitting pattern 1031, the second light-emitting pattern 1032 and the exposed electron transport layer 106 away from the base substrate 101. The metal oxide film 115 is oxide nanoparticles or microcrystals that comprise magnesium and are wrapped by microcapsules. The content of magnesium element in the metal oxide film 115 and the content of magnesium element in the metal oxide films 107 and 111 may be the same or different. The mask 123 is aligned with the array substrate so that the mask 123 exposes the third sub-pixel P3 and blocks the non-target region NP3 (comprising the first sub-pixel P1 and the second sub-pixel P2), and the ultraviolet light less than 260 nm (for example, 254 nm) is used to irradiate the metal oxide film 115. Under the irradiation of ultraviolet light, a de-cross-linking reaction occurs inside the microcapsule in the third sub-pixel P3, causing the microcapsule to rupture. The oxide nanoparticles comprising magnesium that are inside the microcapsules are exposed, so that the patterned third metal oxide pattern 1023 is formed in the third sub-pixel P3. The microcapsules and the oxide nanoparticles comprising magnesium inside the microcapsules that are in the unexposed region NP3 are dissolved and removed by using a solvent or developer, and the ruptured microcapsules at the third sub-pixel P3 in the exposed region are dissolved and removed. Until now, the patterned metal oxide layer 102 is formed.
S708: performing steps S18-S20 according to the steps described in method 500 to form the third light-emitting pattern 1033 in the third sub-pixel P3. Until now, the patterned light-emitting layer 103 is formed.
S709: sequentially forming the hole transport layer 119, the hole injection layer 120, the second electrode layer 121, and the light extraction layer (CPL) 124 according to the step S21 described in the method 500.

In some embodiments, the materials of the electrode layer 104, the electron transport layer 106, the first metal oxide pattern 1021, the first light-emitting pattern 1031, the hole transport layer 119, the hole injection layer 120, and the second electrode layer 121 in the first sub-pixel P1 may respectively be ITO, ZnSnO, ZnMgO-1, RQD, TFB, NiO, and Al. The materials of the electrode layer 104, the electron transport layer 106, the second metal oxide pattern 1022, the second light-emitting pattern 1032, the hole transport layer 119, the hole injection layer 120, and the second electrode layer 121 in the second sub-pixel P2 may respectively be ITO, ZnSnO, ZnMgO-2, GQD, TFB, NiO, and Al. The materials of the electrode layer 104, the electron transport layer 106, the third metal oxide pattern 1023, the third light-emitting pattern 1033, the hole transport layer 119, the hole injection layer 120, and the second electrode layer 121 in the third sub-pixel P3 may respectively be ITO, ZnSnO, ZnMgO-3, BQD, TFB, NiO, and Al.

Different from the method 600, in the method 700, after each exposure of the metal oxide film in the target region, the microcapsules in the unexposed region are removed from the substrate using a developer. In this way, the metal oxide films 107, 111, and 115 may adopt different oxide materials comprising magnesium element, so that more matching oxide nanoparticles comprising magnesium can be used for the quantum dots in different sub-pixels.

In the finished array substrate formed using the method 700, ideally, the molecules of microcapsules will be completely developed. However, in the actual process, a trace amount of molecules of microcapsules may remain in the array substrate. Since it is a trace amount, it will not affect the performance of the device. The structural formulas of these molecules may be referred to the description of method 600 and will not be described again here.

It should be noted that in methods 600 and 700, "photosensitive" microcapsules are used as examples for description. But as described above, the microcapsules may also be thermo-sensitive. For thermo-sensitive microcapsules, thermal stimulation can be used to expose the oxide comprising magnesium. As an example, thermal stimulation of a specific region may adopt any one of the following two ways:
(1) applying a voltage to the electrode layer 104 below the target sub-pixel regions to generate heat, causing the microcapsules in the target sub-pixel regions to rupture and expose the oxide nanoparticles comprising magnesium inside the microcapsules. This thermal stimulation method is suitable for microcapsules with low thermal response temperature. The thermal response temperature should usually be below 120 °C.
(2) using laser to perform thermal annealing on the entire column of the target sub-pixel regions, causing the microcapsules in the column of the target sub-pixel regions to undergo changes such as melting, rupture, or decomposition after being heated, so as to expose the oxide nanoparticles comprising magnesium inside the microcapsules. Using laser as a heat source for heating, the thermal response temperature of the microcapsule can be adjusted according to actual conditions (such as adjusting laser power and action time, etc.), and the thermal response temperature should usually be below 200 °C.

(III) The metal oxide layer 102 is formed of an oxide precursor comprising magnesium.

Next, another method 800 for manufacturing an array substrate is described. Except for the preparation method of the metal oxide layer 102, the steps of the method 800 are basically the same as the steps of the method 500. For the sake of simplicity, only the differences from the method 500 will be introduced in the following. For similarities, please refer to the description of the method 500. The steps of the method 800 are as follows:
S801: preparing the electrode layer 104 and the electron transport layer 106 by using the same method as steps S1-S2. Alternatively, the electron transport layer 106 may be omitted.
S802: applying the metal oxide film 107 on the side of the electron transport layer 106 away from the base substrate 101 by methods such as spin coating, blade coating, spray coating, etc. In this embodiment, the metal oxide film 107 is an oxide precursor comprising magnesium. The oxide precursor comprising magnesium may be prepared in advance.

The preparation method of the oxide precursor comprising magnesium may refer to the following steps.

A certain mass of magnesium acetate and ethanolamine are dissolved in 2-methoxyethanol (ultrasound may be used to accelerate the dissolution). After the magnesium acetate and the ethanolamine are completely dissolved in the solvent, a solution of oxide precursor comprising magnesium is prepared. In an alternative embodiment, a certain mass of magnesium acetate, zinc acetate, and ethanolamine may also be dissolved in 2-methoxyethanol to form the precursor of magnesium zinc oxide. The content of magnesium element can be adjusted by adjusting the ratio of magnesium acetate and zinc acetate. In addition, when elements such as aluminum, gallium, tin, indium, titanium need to be added to the oxide comprising magnesium, the acetate and the magnesium acetate of corresponding element can usually be dissolved in 2-methoxyethanol comprising ethanolamine in the required ratio, to form a solution of oxide precursor comprising magnesium.

S803: Spin-coating (or scrape-coating, spray-coating, etc.) a solution of photocrosslinkable macromolecules (such as macromolecules comprising olefin groups or other macromolecules with photosensitive cross-linking property) or small molecules (such as C18-C30 long-chain alkanes or mixtures thereof) dissolved in a non-polar solvent (such as toluene, chloroform, petroleum ether, octane, hexane, cyclohexane, etc.) on the surface of the above-mentioned metal oxide film 107 (that is, a film of oxide precursor comprising magnesium), to form an organic film of macromolecules or small molecules. The first sub-pixel P1 is exposed to ultraviolet light by using a mask, so that the film of macromolecules or small molecules in the first sub-pixel P1 is exposed and cross-linked. The organic film of macromolecules or small molecules in the unexposed region is then dissolved and eluted by using a specific non-polar solution to expose the oxide precursor comprising magnesium. The exposed oxide precursor comprising magnesium is then dissolved and eluted by using a solvent (such as 2-methoxyethanol) for the oxide precursor comprising magnesium. Then, the oxide precursor comprising magnesium in the first sub-pixel P1 is subjected to a high-temperature annealing treatment (the temperature should generally be greater than or equal to 150 °C and less than 300 °C), so the oxide precursor comprising magnesium in the first sub-pixel P1 is grown and crystallized, thereby forming a first metal oxide pattern 1021 in a crystal form. In an alternative embodiment, the first metal oxide pattern 1021 may be formed using the following method: the laser is used to heat the oxide precursor comprising magnesium in the column (or row) of the first sub-pixel P1, causing the precursor to undergo a physical and chemical reaction and crystallize into a crystal form. The oxide precursor comprising magnesium in the non-target region NP1 is still a precursor solution, and a solvent (such as 2-methoxyethanol) can be used to dissolve and elute the solution of oxide precursor comprising magnesium in the non-target region NP1, thereby forming the first metal oxide pattern 1021 in a crystal form in the first sub-pixel P1.

S804: performing steps S6-S8 according to the steps described in method 500 to form the first light-emitting pattern 1031 in the first sub-pixel P1.

S805: forming a second metal oxide pattern 1022 in crystal form in the second sub-pixel P2 according to the preparation method of step S803.

S806: performing steps S12-S14 according to the steps described in method 500 to form the second light-emitting pattern 1032 in the second sub-pixel P2.

S807: forming a third metal oxide pattern 1023 in crystal form in the third sub-pixel P3 according to the preparation method of step S803. Until now, the patterned metal oxide layer 102 is formed.

S808: performing steps S18-S20 according to the steps described in method 500 to form the third light-emitting pattern 1033 in the third sub-pixel P3. Until now, the patterned light-emitting layer 103 is formed.

S809: sequentially forming the hole transport layer 119, the hole injection layer 120, the second electrode layer 121, and the light extraction layer (CPL) 124 according to the step S21 described in the method 500.

In some embodiments, the materials of the electrode layer 104, the first metal oxide pattern 1021, the first light-emitting pattern 1031, the hole transport layer 119, the hole injection layer 120, and the second electrode layer 121 in the first sub-pixel P1 may respectively be ITO, ZnMgO-1, RQD, PVK (Polyvinylcarbazole), MoOₓ, and Ag. The materials of the electrode layer 104, the second metal oxide pattern 1022, the second light-emitting pattern 1032, the hole transport layer 119, the hole injection layer 120, and the second electrode layer 121 in the second sub-pixel P2 may respectively be ITO, ZnMgO-2, GQD, PVK, MoOₓ, and Ag. The materials of the electrode layer 104, the third metal oxide pattern 1023, the third light-emitting pattern 1033, the hole transport layer 119, the hole injection layer 120, and the second electrode layer 121 in the third sub-pixel P3 may respectively be ITO, ZnMgO-3, BQD, PVK, MoOₓ, and Ag. ZnMgO-1, ZnMgO-2, and ZnMgO-3 may be three different oxides comprising magnesium, which can better meet the needs of different quantum dots.

In the method 800, the layer of oxide comprising magnesium is an oxide precursor comprising magnesium, and a sol-gel reaction occurs in situ on the substrate to form the layer of oxide comprising magnesium in crystal form (the layer is generally denser), rather than to form a layer in the form of nanoparticles or microcrystals. In addition, ligand molecules, such as ethanolamine (HO-CH2-CH2-NH2), diethanolamine (HO-CH2-CH2-NH-CH2-CH2-OH), etc., may exist on the surface of the layer of oxide comprising magnesium.

In addition, it should be noted that since cross-linked macromolecule or small molecule carbon chains are utilized in the method 800, a small amount of organic molecule film may exist above the layer of oxide comprising magnesium, such as a carbon chain cross-linked network film comprising a C18-C25 aliphatic alkane chain. Although the cross-linked network film has been removed or "damaged" in subsequent processes (such as damage to it by the development process and the high-temperature annealing), a trace amount of the cross-linked network film may still remain in the device. Since the residual amount is extremely small, it will not have a negative impact on the performance of the device.

(IV) The metal oxide layer 102 is formed by magnetron sputtering or evaporation by using a fine metal mask (FMM).

Next, another method 900 for manufacturing an array substrate is described. Except for the preparation method of the metal oxide layer 102, the steps of the method 900 are basically the same as the steps of the method 500. For the sake of simplicity, only the differences from the method 500 will be introduced in the following. For similarities, please refer to the description of the method 500. The steps of the method 900 are as follows:
S901: preparing the electrode layer 104 and the electron transport layer 106 by using the same method as steps S1-S2. Alternatively, the electron transport layer 106 may be omitted.
S902: aligning the FMM with the substrate, then using a magnetron sputtering instrument to deposit a layer of oxide comprising magnesium in the first sub-pixel P1 to form a first metal oxide pattern 1021, while no layer of oxide comprising magnesium is deposited in the non-target region NP1.
S903: performing steps S6-S8 according to the steps described in the method 500 to form the first light-emitting pattern 1031 in the first sub-pixel P1.
S904: aligning the FMM with the substrate, then using the magnetron sputtering instrument to deposit a layer of oxide comprising magnesium in the second sub-pixel P2 to form a second metal oxide pattern 1022, while no layer of oxide comprising magnesium is deposited in the non-target region NP2.
S905: performing steps S12-S14 according to the steps described in the method 500 to form the second light-emitting pattern 1032 in the second sub-pixel P2.
S906: aligning the FMM with the substrate, then using the magnetron sputtering instrument to deposit a layer of oxide comprising magnesium in the third sub-pixel P3 to form a third metal oxide pattern 1023, while no layer of oxide comprising magnesium is deposited in the non-target region NP3. Until now, the patterned metal oxide layer 102 is formed.
S907: performing steps S18-S20 according to the steps described in the method 500 to form the third light-emitting pattern 1033 in the third sub-pixel P3. Until now, the patterned light-emitting layer 103 is formed.
S908: sequentially forming the hole transport layer 119, the hole injection layer 120, the second electrode layer 121, and the light extraction layer (CPL) 124 according to the step S21 described in the method 500.

In some embodiments, the materials of the electrode layer 104, the electron transport layer 106, the first metal oxide pattern 1021, the first light-emitting pattern 1031, the hole transport layer 119, the hole injection layer 120, and the second electrode layer 121 in the first sub-pixel P1 may respectively be ITO, ZnGaO, ZnMgO-1, RQD, TCTA, MoOₓ, and IGZO. The materials of the electrode layer 104, the electron transport layer 106, the second metal oxide pattern 1022, the second light-emitting pattern 1032, the hole transport layer 119, the hole injection layer 120, and the second electrode layer 121 in the second sub-pixel P2 may respectively be ITO, ZnGaO, ZnMgO-2, GQD, TCTA, MoOₓ, and IGZO. The materials of the electrode layer 104, the electron transport layer 106, the third metal oxide pattern 1023, the third light-emitting pattern 1033, the hole transport layer 119, the hole injection layer 120, and the second electrode layer 121 in the third sub-pixel P3 may respectively be ITO, ZnGaO, ZnMgO-3, BQD, TCTA, MoOₓ, and IGZO. ZnMgO-1, ZnMgO-2, and ZnMgO-3 may be three different oxides comprising magnesium, which can better meet the needs of different quantum dots.

In the array substrate formed by the method 900, since the metal oxide layer 102 is formed using a sputtering process, the metal oxide layer 102 is the densest, and there are no additional organic ligand molecules on the surface of the metal oxide layer 102 or in its interior.

Next, another method 1000 for manufacturing an array substrate is described. Except for the preparation method of the metal oxide layer 102, the steps of the method 1000 are basically the same as the steps of the method 500. For the sake of simplicity, only the differences from the method 500 will be introduced in the following. For similarities, please refer to the description of the method 500. The steps of the method 1000 are as follows:
S1001: preparing the electrode layer 104 and the electron transport layer 106 by using the same method as steps S1-S2. In this embodiment, the thickness of the electron transport layer 106 cannot be zero.
S1002: aligning the FMM with the substrate, then using an evaporation machine or a magnetron sputtering instrument to deposit the metal magnesium (Mg) on the surface of the electron transport layer 106 in the first sub-pixel P1, while no metal magnesiuml is deposited in the non-target region NP1. The thickness of the deposited Mg should range from 1~6 nm, such as 1 nm, 2 nm, 3 nm, 4 nm, 5 nm, 6 nm, and the maximum thickness should not exceed 6 nm.
S1003: exposing the substrate on which the Mg layer is deposited to an atmosphere comprising oxygen (which may be an atmosphere with a higher concentration of oxygen, such as a dried atmosphere, etc.), so that the surface of Mg is oxidized to MgO, thereby forming a first metal oxide pattern 1021.
S1004: performing steps S6-S8 according to the steps described in the method 500 to form the first light-emitting pattern 1031 in the first sub-pixel P1.
S1005: forming metal magnesium (Mg) in the second sub-pixel P2 according to the method of steps S1002 and S1003, and exposing the substrate on which the Mg layer is deposited to an atmosphere comprising oxygen, so that the surface of Mg is oxidized to MgO, thereby forming a second metal oxide pattern 1022.
S1006: performing steps S12-S14 according to the steps described in the method 500 to form the second light-emitting pattern 1032 in the second sub-pixel P2.
S1007: forming metal magnesium (Mg) in the third sub-pixel P3 according to the method of steps S1002 and S1003, and exposing the substrate on which the Mg layer is deposited to an atmosphere comprising oxygen, so that the surface of Mg is oxidized to MgO, thereby forming a third metal oxide pattern 1023. Until now, the patterned metal oxide layer 102 is formed.
S1008: performing steps S18-S20 according to the steps described in the method 500 to form the third light-emitting pattern 1033 in the third sub-pixel P3. Until now, the patterned light-emitting layer 103 is formed.
S1009: sequentially forming the hole transport layer 119, the hole injection layer 120, the second electrode layer 121, and the light extraction layer (CPL) 124 according to the step S21 described in the method 500.

In some embodiments, the materials of the electrode layer 104, the electron transport layer 106, the first metal oxide pattern 1021, the first light-emitting pattern 1031, the hole transport layer 119, the hole injection layer 120, and the second electrode layer 121 in the first sub-pixel P1 may respectively be Mo+Ag+ITO, ZnO-BN, MgO-1, RQD, NiO, MoOₓ, and Mg+Al. The materials of the electrode layer 104, the electron transport layer 106, the second metal oxide pattern 1022, the second light-emitting pattern 1032, the hole transport layer 119, the hole injection layer 120, and the second electrode layer 121 in the second sub-pixel P2 may respectively be Mo+Ag+ITO, ZnO-BN, MgO-2, GQD, NiO, MoOₓ, and Mg+Al. The materials of the electrode layer 104, the electron transport layer 106, the third metal oxide pattern 1023, the third light-emitting pattern 1033, the hole transport layer 119, the hole injection layer 120, and the second electrode layer 121 in the third sub-pixel P3 may respectively be Mo+Ag+ITO, ZnO-BN, MgO-3, BQD, NiO, MoOₓ, and Mg+Al. MgO-1, MgO-2, and MgO-3 can be doped with different proportions of magnesium element to better meet the needs of different quantum dots.

In the method 1000, the array substrate needs to comprise the electron transport layer 106 that does not comprise magnesium element, and the material of the metal oxide layer 102 is MgO. The thickness of the metal oxide layer 102 may be, for example, 1 nm, 2 nm, 3 nm, 4 nm, 5 nm.

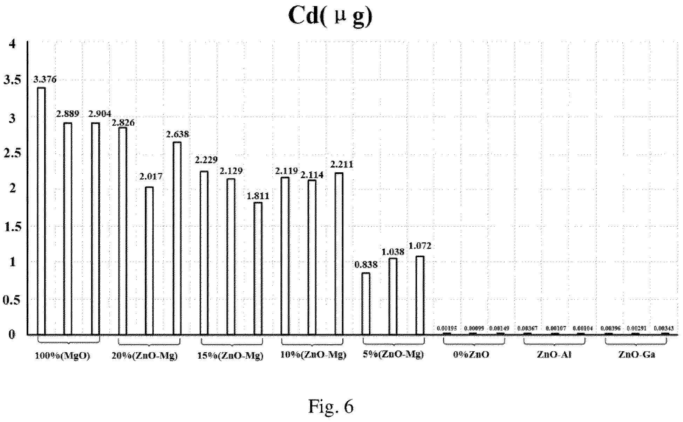

Fig. 6 illustrates the amount of cadmium-based (Cd) quantum dots left on the surfaces of different metal oxides after the same amount of cadmium-based quantum dots are spin-coated on the surfaces of different metal oxides and the same powerful developer is used to develop the cadmium-based quantum dots (soaking + cleaning with flowing solution). In this experiment, the thickness of the metal oxide is 40 nm. The abscissas of Fig. 6 are respectively the metal oxide MgO with a content of magnesium of 100%, the metal oxide ZnO-Mg with a content of magnesium of 20%, the metal oxide ZnO-Mg with a content of magnesium of 15%, the metal oxide ZnO-Mg with a content of magnesium of 10%, the metal oxide ZnO-Mg with a content of magnesium of 5%, the metal oxide ZnO with a content of magnesium of 0%, ZnO doped with Al, and ZnO doped with Ga. The unit of the ordinate is µg, which represents the amount of cadmium-based quantum dots left on the surface of the metal oxide. Three data were collected for each metal oxide, and the average of the three data can be taken as a representation of the bonding force between the metal oxide and the cadmium-based quantum dots. The greater the average is, the greater the amount of quantum dots left after development is, indicating that the bonding force between the metal oxide and the quantum dots is greater. On the contrary, the smaller the average is, the smaller the amount of quantum dots left after development is, indicating that the bonding force between the metal oxide and the quantum dots is smaller. It can be seen from Fig. 6 that, the average corresponding to the metal oxide MgO with a content of magnesium of 100% is 3.056=(3.376+2.889+2.904)/3, the average corresponding to the metal oxide ZnO-Mg with a content of magnesium of 20% is 2.494=(2.826+2.017+2.638)/3, the average corresponding to the metal oxide ZnO-Mg with a content of magnesium of 15% is 2.056=(2.229+2.129+1.811)/3, the average corresponding to the metal oxide ZnO-Mg with a content of magnesium of 10% is 2.148=(2.119+2.114+2.211)/3, the average corresponding to the metal oxide ZnO-Mg with a content of magnesium of 5% is 0.983=(0.838+1.038+1.072)/3, the average corresponding to the metal oxide ZnO with a content of magnesium of 0% is 0.00148=(0.00195+0.00099+0.00149)/3, the average corresponding to the ZnO doped with Al is 0.00193=(0.00367+0.00107+0.00104)/3, the average corresponding to the ZnO doped with Ga is 0.00343=(0.00396+0.00291+0.00343)/3. It can be seen that the average corresponding to the metal oxide doped with magnesium element is much greater than the average corresponding to the metal oxide not doped with magnesium element. This illustrates that the introduction of magnesium element into the metal oxide layer can significantly increase the bonding force between the metal oxide and the quantum dots, making it difficult for the quantum dots to be eluted from the surface of the metal oxide by the powerful developer.

The oxides comprising magnesium and zinc oxides used in the above experiment are prepared by magnetron sputtering. MgO/ZnO are prepared by sputtering MgO target/ZnO target respectively, ZnO-Al/ZnO-Ga are prepared by co-sputtering of ZnO target+Al₂O₃ target/ZnO target+Ga₂O₃ target respectively. ZnO doped with different amounts of Mg is prepared by co-sputtering of MgO target and ZnO target. During sputtering, the doping content of Mg element is controlled by adjusting the power of different targets. The power of the MgO target can be increased and/or the power of the ZnO target can be reduced so as to increase the Mg content. In the related art, the surface roughness of ZnO film formed by magnetron sputtering is usually between 0.8 nm~10 nm. In this application, the surface roughness of ZnO film formed by magnetron sputtering is between 1~2 nm. It can be seen that the surface of the ZnO film has good flatness.

It should be noted that although the above experimental data are obtained by the metal oxides that are prepared by magnetron sputtering, the film prepared by spin-coating nanoparticles such as zinc oxide or magnesium zinc oxide, and the zinc oxide film and/or magnesium zinc oxide film prepared by thermal annealing and sol-gel transition after coating with zinc oxide or magnesium zinc oxide precursor sol solution, have the same trend as that in Fig. 6, that is, quantum dots have stronger bonding force with the oxide comprising magnesium and are not easy to be washed off by the developer.

It will be understood that although the terms first, second, third, etc. may be used herein to describe various elements, components, regions, layers and/or portions, these elements, components, regions, layers and/or portions should not be limited by these terms. These terms are only used to distinguish an element, component, region, layer or portion from another element, component, region, layer or portion. Thus, a first element, component, region, layer or portion discussed above could be termed a second element, component, region, layer or portion without departing from the teachings of the present disclosure.

Spatially relative terms such as "row", "column", "below", "above", "left", "right", etc. may be used herein for ease of description to describe factors such as the relationship of an element or feature to another element(s) or feature(s) illustrated in the figures. It will be understood that these spatially relative terms are intended to encompass different orientations of the device in use or operation in addition to the orientation depicted in the figures. For example, if the device in the figures is turned over, elements described as "below" other elements or features would then be oriented "above" other elements or features. Thus, the exemplary term "below" can encompass both an orientation of above and below. The device may be otherwise oriented (rotated 90 degrees or at other orientations) and the spatially relative descriptors used herein are interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to limit the present disclosure. As used herein, the singular forms "a," "an," and "the" are intended to comprise the plural forms as well, unless the context clearly dictates otherwise. It will be further understood that the terms "comprise" and/or "include" when used in this specification designate the presence of stated features, integers, steps, operations, elements and/or parts, but do not exclude the presence or addition of one or more other features, integers, steps, operations, elements, components and/or groups thereof. As used herein, the term "and/or" comprises any and all combinations of one or more of the associated listed items. In the description of this specification, description with reference to the terms "an embodiment," "another embodiment," etc. means that a particular feature, structure, material, or characteristic described in connection with the embodiment is included in at least one embodiment of the present disclosure. In this specification, schematic representations of the above terms are not necessarily directed to the same embodiment or example. Furthermore, the particular features, structures, materials or characteristics described may be combined in any suitable manner in any one or more embodiments or examples. Furthermore, those skilled in the art may combine the different embodiments or examples as well as the features of the different embodiments or examples described in this specification without conflicting each other.

It will be understood that when an element or layer is referred to as being "on", "connected to", "coupled to", or "adjacent to" another element or layer, it may be directly on, directly connected to, directly coupled to, or directly adjacent to another element or layer, or intervening elements or layers may be present. In contrast, when an element is referred to as being "directly on", "directly connected to", "directly coupled to", "directly adjacent to" another element or layer, with no intervening elements or layers present. However, in no case should "on" or "directly on" be interpreted as requiring a layer to completely cover the layer below.

Embodiments of the disclosure are described herein with reference to schematic illustrations (and intermediate structures) of idealized embodiments of the disclosure. As such, variations to the shapes of the illustrations are to be expected, e.g., as a result of manufacturing techniques and/or tolerances. Accordingly, embodiments of the present disclosure should not be construed as limited to the particular shapes of the regions illustrated herein, but are to comprise deviations in shapes due, for example, to manufacturing. Thus, the regions illustrated in the figures are schematic in nature and their shapes are not intended to illustrate the actual shape of a region of a device and are not intended to limit the scope of the present disclosure.

Unless otherwise defined, all terms (comprising technical and scientific terms) used herein have the same meaning as commonly understood by one of ordinary skill in the art to which this disclosure belongs. It will be further understood that terms such as those defined in commonly used dictionaries should be construed to have meanings consistent with their meanings in the relevant art and/or the context of this specification, and will not be idealized or overly interpreted in a formal sense, unless expressly defined as such herein.

The above descriptions are merely specific embodiments of the present disclosure, but the protection scope of the present disclosure is not limited thereto. Any changes or substitutions that those skilled in the art can easily think of within the technical scope disclosed by the present disclosure, should be comprised within the protection scope of the present disclosure. Therefore, the protection scope of the present disclosure should be based on the protection scope of the claims.

## Claims

1. An array substrate comprising:
a base substrate comprising a plurality of sub-pixels arranged in an array;
a patterned metal oxide layer on the base substrate and in the plurality of sub-pixels, a portion of the metal oxide layer in any one of the plurality of sub-pixels being spaced apart from a portion of the metal oxide layer in another sub-pixel adjacent to the any one sub-pixel; and
a patterned light-emitting layer on a side of the metal oxide layer away from the base substrate and in the plurality of sub-pixels,
wherein the metal oxide layer comprises at least one of magnesium element and calcium element, and the light-emitting layer comprises a photosensitive material and is in contact with the metal oxide layer.

2. The array substrate according to claim 1, wherein the metal oxide layer comprises the magnesium element.

3. The array substrate according to claim 2, wherein a material of the metal oxide layer comprises an oxide nanoparticle comprising the magnesium element, and a surface of the oxide nanoparticle comprising the magnesium element has photosensitive ligand molecules.

4. The array substrate according to claim 3, wherein a structural formula of the oxide nanoparticle comprising the magnesium element is 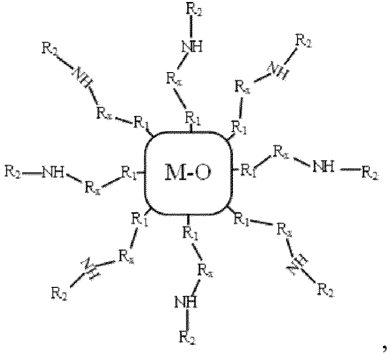 the surface of the oxide nanoparticle having the photosensitive ligand molecules,
where M-O represents the oxide nanoparticle comprising the magnesium element, 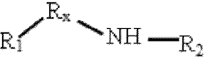 represents a respective one of the photosensitive ligand molecules, R₁ is selected from one of hydroxyl, sulfydryl, amino, carbonyl, carboxyl and ester group, R₂ is selected from one of hydrogen atom, methyl, ethyl, propyl and isopropyl, and Rₓ is an aliphatic alkane chain with 1 to 6 carbon atoms.

5. The array substrate according to claim 3, wherein a structural formula of the oxide nanoparticle comprising the magnesium element is 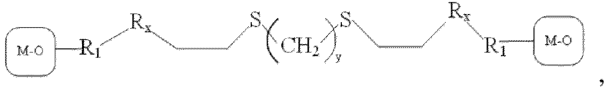 the surface of the oxide nanoparticle having the photosensitive ligand molecules,
where M-O represents the oxide nanoparticle comprising the magnesium element, 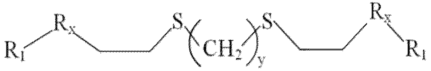 represents a respective one of the photosensitive ligand molecules between two adjacent oxide nanoparticles comprising the magnesium element, R₁ is selected from one of hydroxyl, sulfydryl, amino, carbonyl, carboxyl and ester group, Rₓ is an aliphatic alkane chain with 1 to 18 carbon atoms or a carbon molecular chain, a main chain of the carbon molecular chain comprises one of nitrogen atom, oxygen atom, and sulfur atom, 1<y≤18.

6. The array substrate according to claim 2, further comprising a ruptured microcapsule, wherein the ruptured microcapsule is between the base substrate and the light-emitting layer and exposes the metal oxide layer, a material of the microcapsule comprises a macromolecular material having at least one side chain, and the side chain comprises a reversible chemical bond.

7. The array substrate according to claim 2, wherein a material of the metal oxide layer comprises a crystal comprising the magnesium element.

8. The array substrate according to any one of claims 1-7, wherein the light-emitting layer is a quantum dot, each sub-pixel comprises target quantum dots and non-target quantum dots which are residual and trace, and a number of the non-target quantum dots residual in a unit area of each sub-pixel is 0~500 pcs/µm².

9. The array substrate according to claim 8, wherein the number of the non-target quantum dots residual in the unit area of each sub-pixel is 0.5~85 pcs/µm².

10. The array substrate according to any one of claims 2-9, wherein a material of the metal oxide layer is selected from at least one of MgO, ZnMgO, MgO with a dopant, or ZnMgO with a dopant, the MgO with the dopant or the ZnMgO with the dopant being doped with at least one of Al, Ga, Sn, In, or Ti.

11. The array substrate according to claim 10, wherein a content of the magnesium element in the metal oxide layer is greater than or equal to 1.5%, the content of the magnesium element in the metal oxide layer refers to a percentage of a molar amount of the magnesium element in the metal oxide layer to a sum of molar amounts of all metal elements in the metal oxide layer.

12. The array substrate according to claim 10, wherein a thickness of the metal oxide layer is less than or equal to 100 nm.

13. The array substrate according to claim 12,
wherein the thickness of the metal oxide layer is less than or equal to 8 nm, and a maximum of a content of the magnesium element in the metal oxide layer is 1.5%~100%; or
wherein the thickness of the metal oxide layer is greater than or equal to 8 nm, and a maximum of a content of the magnesium element in the metal oxide layer is 1.5%~40%,
wherein the content of the magnesium element in the metal oxide layer refers to a percentage of a molar amount of the magnesium element in the metal oxide layer to a sum of molar amounts of all metal elements in the metal oxide layer.

14. The array substrate according to claim 13, wherein the thickness of the metal oxide layer is greater than or equal to 15 nm and less than or equal to 60 nm, and the maximum of the content of the magnesium element in the metal oxide layer is 2%~20%.

15. The array substrate according to any one of claims 1-14, further comprising an electrode layer between the base substrate and the metal oxide layer, wherein the metal oxide layer is in direct contact with a surface of the electrode layer away from the base substrate.

16. The array substrate according to any one of claims 1-14, further comprising:
a pixel defining layer on the base substrate and between any two adjacent sub-pixels of the plurality of sub-pixels, the pixel defining layer comprising a sidewall and a top surface on a side away from the base substrate; and
an electron transport layer in the plurality of sub-pixels and covering the sidewall and the top surface of the pixel defining layer, a portion of the electron transport layer in the plurality of sub-pixels being between the base substrate and the metal oxide layer.

17. The array substrate according to claim 16, wherein a material of the electron transport layer does not comprise magnesium.

18. The array substrate according to claim 17, wherein a material of the metal oxide layer is MgO, and a ratio of a thickness of the MgO to a thickness of the electron transport layer is 1:80-1:1.

19. The array substrate according to any one of claims 16-18, wherein the metal oxide layer covers the sidewall of the pixel defining layer.

20. The array substrate according to any one of claims 1-19, wherein an orthographic projection of the light-emitting layer on the base substrate substantially overlaps with an orthographic projection of the metal oxide layer on the base substrate.

21. The array substrate according to any one of claims 1-14 and 16-20, further comprising:
a first electrode layer between the base substrate and the metal oxide layer;
a hole transport layer on a side of the light-emitting layer away from the base substrate;
a hole injection layer on a side of the hole transport layer away from the base substrate; and
a second electrode layer on a side of the hole injection layer away from the base substrate.

22. An array substrate comprising:
a base substrate comprising a plurality of sub-pixels arranged in an array;
a first electrode layer on the base substrate;
a pixel defining layer on the base substrate and between any two adjacent sub-pixels of the plurality of sub-pixels, the pixel defining layer comprising a sidewall and a top surface on a side away from the base substrate;
an electron transport layer on a side of the first electrode layer away from the base substrate, the electron transport layer being arranged in the plurality of sub-pixels and covering the sidewall and the top surface of the pixel defining layer;
a patterned metal oxide layer on a side of the electron transport layer away from the base substrate and in the plurality of sub-pixels, a portion of the metal oxide layer in any one of the plurality of sub-pixels being spaced apart from a portion of the metal oxide layer in another sub-pixel adjacent to the any one sub-pixel by the pixel defining layer, the metal oxide layer comprising at least one of magnesium element and calcium element;
a patterned light-emitting layer on a side of the metal oxide layer away from the base substrate and in the plurality of sub-pixels;
a hole transport layer on a side of the light-emitting layer away from the base substrate;
a hole injection layer on a side of the hole transport layer away from the base substrate; and
a second electrode layer on a side of the hole injection layer away from the base substrate.

23. The array substrate according to claim 22, wherein a material of the electron transport layer does not comprise magnesium, a material of the metal oxide layer is MgO, and a ratio of a thickness of the MgO to a thickness of the electron transport layer is 1:80~1:1.

24. A display device comprising:
the array substrate according to any one of claims 1-21 or the array substrate according to any one of claims 22-23; and
a counter substrate opposite to the array substrate.

25. A method of manufacturing an array substrate comprising:
providing a base substrate that comprises a plurality of sub-pixels arranged in an array;
forming a patterned metal oxide layer on the base substrate and forming a patterned light-emitting layer on a side of the metal oxide layer away from the base substrate,
wherein the metal oxide layer comprises at least one of magnesium element and calcium element, both the metal oxide layer and the light-emitting layer are in the plurality of sub-pixels, and a portion of the metal oxide layer in any one of the plurality of sub-pixels is spaced apart from a portion of the metal oxide layer in another sub-pixel adjacent to the any one sub-pixel, and
wherein the light-emitting layer comprises a photosensitive material and is in contact with the metal oxide layer.

26. The method according to claim 25, wherein the plurality of sub-pixels comprise a first sub-pixel, a second sub-pixel, and a third sub-pixel, the forming the patterned metal oxide layer on the base substrate and forming the patterned light-emitting layer on the side of the metal oxide layer away from the base substrate, comprises:
applying a first metal oxide film on the base substrate, patterning the first metal oxide film to form a first metal oxide pattern in the first sub-pixel;
applying a first light-emitting layer film on a side of the first metal oxide pattern away from the base substrate, patterning the first light-emitting layer film to form a first light-emitting pattern in direct contact with the first metal oxide pattern in the first sub-pixel;
applying a second metal oxide film on a side of the first light-emitting pattern away from the base substrate, patterning the second metal oxide film to form a second metal oxide pattern in the second sub-pixel; and
applying a second light-emitting layer film on a side of the first light-emitting pattern and the second metal oxide pattern away from the base substrate, patterning the second light-emitting layer film to form a second light-emitting pattern in direct contact with the second metal oxide pattern in the second sub-pixel,
wherein the metal oxide layer comprises the first metal oxide pattern and the second metal oxide pattern, and the light-emitting layer comprises the first light-emitting pattern and the second light-emitting pattern.

27. The method according to claim 26, wherein a bonding force between the light-emitting layer and the metal oxide layer is greater than a bonding force between the light-emitting layer and the base substrate.

28. The method according to claim 26, wherein the first metal oxide film and the second metal oxide film have a photosensitive or thermo-sensitive property, and the first light-emitting layer film and the second light-emitting layer film have a photosensitive property.

29. The method according to any one of claims 26-28,
wherein the first metal oxide pattern is prepared by following operations:
applying the first metal oxide film on the base substrate, a material of the first metal oxide film comprising an oxide nanoparticle comprising the magnesium element, a surface of the oxide nanoparticle having photosensitive ligand molecules;
exposing the first sub-pixel by using a mask to allow ultraviolet light to pass through the mask to expose the first metal oxide film, to cross-link the photosensitive ligand molecules;
developing the first metal oxide film by using a developer to form the first metal oxide pattern in the first sub-pixel;
wherein the second metal oxide pattern is prepared by following operations:
applying the second metal oxide film on the side of the first light-emitting pattern away from the base substrate, a material of the second metal oxide film comprising an oxide nanoparticle comprising the magnesium element, a surface of the oxide nanoparticle having photosensitive ligand molecules;
exposing the second sub-pixel by using a mask to allow ultraviolet light to pass through the mask to expose the second metal oxide film, to cross-link the photosensitive ligand molecules; and
developing the second metal oxide film by using a developer to form the second metal oxide pattern in the second sub-pixel.

30. The method according to any one of claims 26-28,
wherein the first metal oxide pattern is prepared by following operations:
applying the first metal oxide film on the base substrate, a material of the first metal oxide film comprising an oxide nanoparticle that comprises the magnesium element and is wrapped by a microcapsule, the microcapsule having a photosensitive or thermo-sensitive property; and
exposing the first sub-pixel by using a mask, irradiating the first metal oxide film by using ultraviolet light or heating the first metal oxide film to rupture the microcapsule in the first sub-pixel to expose the oxide nanoparticle comprising the magnesium element, so as to form the first metal oxide pattern in the first sub-pixel,
wherein the second metal oxide pattern is prepared by following operations:
applying the second metal oxide film on the side of the first light-emitting pattern away from the base substrate, a material of the second metal oxide film comprising an oxide nanoparticle that comprises the magnesium element and is wrapped by a microcapsule, the microcapsule having a photosensitive or thermo-sensitive property; and
exposing the second sub-pixel by using a mask, irradiating the second metal oxide film by using ultraviolet light or heating the second metal oxide film to rupture the microcapsule in the second sub-pixel to expose the oxide nanoparticle comprising the magnesium element, so as to form the second metal oxide pattern in the second sub-pixel.

31. The method according to claim 30, wherein a structural formula of the microcapsule is: 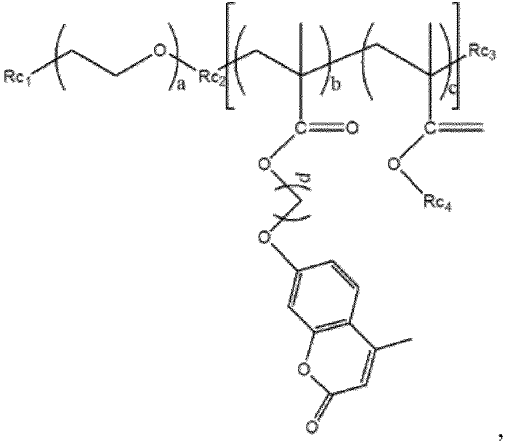 where Rc₁ and Rc₃ are hydrogen atoms or alkane groups, Rc₂ and Rc₄ are alkane groups, a≥60, b+c≥30 and b≥16, 1≤d≤20.

32. The method according to any one of claims 26-28,
wherein the first metal oxide pattern is prepared by following operations:
applying the first metal oxide film on the base substrate, a material of the first metal oxide film comprising an oxide precursor comprising the magnesium element;
applying an intermediate layer with a photosensitive property on the side of the first metal oxide film away from the base substrate;
exposing the first sub-pixel by using a mask to allow ultraviolet light to pass through the mask to expose the intermediate layer;
dissolving an unexposed portion of the intermediate layer by using a developer to expose the oxide precursor comprising the magnesium element, and dissolving the exposed oxide precursor comprising the magnesium element by using a solvent; and
performing a high-temperature annealing process on the first sub-pixel, and forming the first metal oxide pattern by crystallizing the oxide precursor comprising the magnesium element in the first sub-pixel,
wherein the second metal oxide pattern is prepared by following operations:
applying the second metal oxide film on the side of the first light-emitting pattern away from the base substrate, a material of the second metal oxide film comprising an oxide precursor comprising the magnesium element;
applying an intermediate layer with a photosensitive property on the side of the second metal oxide film away from the base substrate;
exposing the second sub-pixel by using a mask to allow ultraviolet light to pass through the mask to expose the intermediate layer;
dissolving an unexposed portion of the intermediate layer by using a developer to expose the oxide precursor comprising the magnesium element, and dissolving the exposed oxide precursor comprising the magnesium element by using a solvent; and
performing a high-temperature annealing process on the second sub-pixel, and forming the second metal oxide pattern by crystallizing the oxide precursor comprising the magnesium element in the second sub-pixel.

33. The method according to claim 25, wherein the forming a patterned metal oxide layer on the base substrate, comprises:
forming the patterned metal oxide layer on the base substrate by magnetron sputtering or evaporation by using a fine metal mask.
